# EUROPEAN PATENT APPLICATION

(11) **EP 4 109 576 A2**
(43) Date of publication of application: **28.12.2022**
(21) Application number: 22179958.8
(22) Date of filing: 20.06.2022
(51) Int. Cl.: H01L 51/52, H01L 27/32

(54) **ORGANIC DEVICE, GROUP OF MASKS, MASK, AND MANUFACTURING METHOD FOR ORGANIC DEVICE**

(30) Priority: 21.06.2021 JP 2021102760; 10.06.2022 JP 2022094333
(71) Applicant: DAI NIPPON PRINTING CO., LTD., Tokyo-to, 162-8001 (JP)
(72) Inventor: MIYATANI, Isao, Tokyo-to, 162-8001 (JP); IKENAGA, Chikao, Tokyo-to, 162-8001 (JP); NAKAMURA, Yoko, Tokyo-to, 162-8001 (JP); INOUE, Isao, Tokyo-to, 162-8001 (JP)
(74) Representative: Müller-Boré & Partner Patentanwälte PartG mbB

(57) **Abstract**

An organic device may include a substrate, first electrodes located on top of the substrate, organic layers located on top of the first electrodes, and a second electrode located on top of the organic layers. When seen along a direction normal to the substrate, the organic device may include a display area including a first display area and a second display area. The first display area may include the organic layers distributed at a first density. The second display area may include the organic layers distributed at a second density that is lower than the first density. The second electrode may include a wide-area electrode spreading in a gapless manner in the first display area and two or more electrode lines overlapping the organic layers in the second display area. Each of the electrode lines includes an end connected to the wide-area electrode.

## Description

### BACKGROUND

### 1. Field

The present disclosure relates to an organic device, a group of masks, a mask, and a manufacturing method for an organic device.

### 2. Description of the Related Art

Recently, in the field of electronic devices such as smartphones and tablet PCs, there has been market demand for high-definition display devices. A display device has a pixel density of, for example, 400 ppi or higher or 800 ppi or higher.

Organic EL display devices have attracted attention because of their high responsivity and/or low power consumption. As a method for forming pixels of an organic EL display device, there has been known a method for causing a material that constitutes the pixels to adhere to a substrate by vapor deposition. For example, first, a substrate having anodes formed in a pattern corresponding to elements is prepared. Then, organic layers are formed on top of the anodes by causing an organic material to adhere onto the top of the anodes via through holes of a mask. Then, a cathode is formed on top of the organic layers by causing an electrically-conducting material to adhere onto the top of the organic layers via a through hole of a mask.

Patent Document 1: Japanese Patent No. 3539597

### SUMMARY

The larger the area of the cathode is, the lower the electric resistance of the cathode becomes. Meanwhile, the larger the area of the cathode is, the lower the transmittance of light in the organic device becomes.

An organic device according to an embodiment of the present disclosure may include a substrate, first electrodes located on top of the substrate, organic layers located on top of the first electrode, and a second electrode located on top of the organic layers. When seen along a direction normal to the substrate, the organic device may include a display area including a first display area and a second display area. The first display area may include the organic layers distributed at a first density. The second display area may include the organic layers distributed at a second density that is lower than the first density. The second electrode may include a wide-area electrode spreading in a gapless manner in the first display area and two or more electrode lines overlapping the organic layers in the second display area. Each of the electrode lines may include an end connected to the wide-area electrode.

An embodiment of the present disclosure makes it possible to increase the transmittance of light in the organic device.

### BRIEF DESCRIPTION OF THE DRAWINGS

Fig. 1 is a plan view showing an example of an organic device.
Fig. 2 is an enlarged plan view showing the organic device.
Fig. 3 is a partially-enlarged plan view showing a first display area and a second display area of Fig. 2.
Fig. 4 is a plan view showing an example of a configuration of a second electrode.
Fig. 5 is a plan view showing the organic device with the second electrode removed therefrom in Fig. 4.
Fig. 6 is a cross-sectional view of the organic device as taken along line A-A in Fig. 4.
Fig. 7 is a cross-sectional view of the organic device as taken along line B-B in Fig. 4.
Fig. 8A is a cross-sectional view of the organic device as taken along line C-C in Fig. 4.
Fig. 8B is a cross-sectional view showing an example of a first overlap area.
Fig. 8C is a cross-sectional view showing an example of a first overlap area.
Fig. 8D is a cross-sectional view of the organic device as taken along line D-D in Fig. 4.
Fig. 8E is a cross-sectional view showing an example of a second overlap area.
Fig. 9 is a plan view showing an example of a group of organic devices.
Fig. 10 is a diagram showing an example of a vapor deposition apparatus.
Fig. 11 is a plan view showing an example of a mask device.
Fig. 12 is a diagram showing an example of a first mask device.
Fig. 13 is a diagram showing an example of a second mask device.
Fig. 14 is a diagram showing an example of a cross-sectional structure of a mask.
Fig. 15 is a diagram showing an example of a first mask.
Fig. 16 is a diagram showing an example of a second mask.
Fig. 17 is a plan view showing an example of a mask stack.
Fig. 18 is a plan view showing an example of an organic device.
Fig. 19 is a diagram showing an example of a first mask device.
Fig. 20 is a diagram showing an example of a second mask device.

### DESCRIPTION OF THE EMBODIMENTS

In the present specification and the present drawings, unless otherwise specifically described, terms, such as "substrate" "base material", "plate", "sheet", and "film", that mean a matter forming the basis of a certain component are not distinguished from one another solely on the basis of the difference in designation.

In the present specification and the present drawings, unless otherwise specifically described, shapes and geometric conditions, terms, such as "parallel" and "orthogonal", that specify the extents of the shapes and the geometric conditions, and values, such as lengths and angles, that specify the extents of the shapes and the geometric conditions are not bound by the strict sense but are construed with the inclusion of a range of extents to which similar functions may be expected.

In the present specification and the present drawings, unless otherwise specifically described, cases where a certain component such as a certain member or a certain area is "on top of" or "under", "on the upper side" or "on the lower side", or "above" or "below" another component such as another member or another area encompass cases where a certain component is in direct contact with another component. Furthermore, the cases also encompass cases where a different component is included between a certain component and another component, i.e. cases where a certain component is in indirect contact with another component. Further, unless otherwise specifically described, the words and phrases such as "on top of", "on the upper side", "above", "under", "on the lower side", and " below" may be turned upside down in meaning.

In the present specification and the present drawings, unless otherwise specifically described, identical components or components having similar functions may be assigned identical or similar signs, and a repeated description of such components may be omitted. Further, for convenience of explanation, dimensional ratios in the drawings may be different from actual ratios, or some components may be omitted from the drawings.

In the present specification and the present drawings, unless otherwise specifically described, an embodiment of the present specification may be combined with another embodiment unless a contradiction arises. Further, other embodiments may be combined with each other unless a contradiction arises.

In the present specification and the present drawings, unless otherwise specifically described, in a case where a plurality of steps are disclosed regarding a method such as a manufacturing method, another step that is not disclosed may be executed between steps that are disclosed. Further, the steps that are disclosed may be executed in any order unless a contradiction arises.

In the present specification and the present drawings, unless otherwise specifically described, a range expressed by the preposition "to" includes a numerical value or element placed before "to" and a numerical value or element placed after "to". For example, the range of numerical values defined by the expression "34 to 38 mass%" is identical to the range of numerical values defined by the expression "34 mass% or higher and 38 mass% or lower". For example, the range defined by the expression "masks 50A to 50B" encompasses masks 50A and 50B.

An embodiment of the present specification illustrates an example in which a group of masks including a plurality of masks is used to form electrodes on top of a substrate in manufacturing an organic EL display device. Note, however, that the group of masks is not limited to particular applications, and the present embodiment can be applied to a group of masks that is used for various purposes. For example, a group of masks of the present embodiment may be used to form electrodes of an apparatus for displaying or projecting an image for expressing virtual reality, so-called VR, or augmented reality, so-called AR. Further, the group of masks of the present embodiment may be used to form electrodes of a display device other than an organic EL display device, such as electrodes of a liquid crystal display device. Further, the group of masks of the present embodiment may be used to form electrodes of an organic device other than a display device, such as electrodes of a pressure sensor.

A first aspect of the present disclosure is directed to an organic device including:
a substrate;
first electrodes located on top of the substrate;
organic layers located on top of the first electrodes; and
a second electrode located on top of the organic layers, wherein
when seen along a direction normal to the substrate, the organic device includes a display area including a first display area and a second display area,
the first display area includes the organic layer distributed at a first density,
the second display area includes the organic layer distributed at a second density that is lower than the first density, and
the second electrode includes a wide-area electrode spreading in a gapless manner in the first display area and two or more electrode lines overlapping the organic layers in the second display area, each of the electrode lines including an end connected to the wide-area electrode.

A second aspect of the present disclosure may be directed to the organic device according to the first aspect, wherein the display area may include contours including first and second sides that are opposite to each other in a first direction and third and fourth sides that are opposite to each other in a second direction intersecting the first direction. The wide-area electrode may spread along the first side, the second side, and the third side.

A third aspect of the present disclosure may be directed to the organic device according to the second aspect, wherein the second display area may be in contact with the fourth side.

A fourth aspect of the present disclosure may be directed to the organic device according to each of the first to third aspects, wherein each of the electrode lines may include a pixel section overlapping at least one of the organic layers and a connection section connected to the pixel section, the connection section having a width that is smaller than a width of the pixel section.

A fifth aspect of the present disclosure may be directed to the organic device according to the fourth aspect, wherein the second electrode may include a first layer constituting at least the wide-area electrode and a second layer partially overlapping the first layer and constituting at least the connection section.

A sixth aspect of the present disclosure may be directed to the organic device according to the fifth aspect, wherein the first layer may include portions, each of the portions constituting the pixel section.

A seventh aspect of the present disclosure may be directed to the organic device according to the sixth aspect, wherein each of the portions of the first layer constituting the pixel section may overlap two or more of the organic layers.

An eighth aspect of the present disclosure may be directed to the organic device according to the sixth aspect, wherein each of the portions of the first layer constituting the pixel section may overlap one of the organic layers.

A ninth aspect of the present disclosure may be directed to the organic device according to each of the first to eighth aspects, wherein a ratio of the second density to the first density may be 0.9 or lower.

A tenth aspect of the present disclosure is directed to a group of masks including two or more masks,
wherein
each of the masks includes a shielding area and at least one through hole,
a mask stack of the two or more masks includes a through area that overlaps the at least one through hole when seen along a direction normal to the masks,
when seen along the direction normal to the masks, the mask stack includes a cell including a mask first area and a mask second area,
in the mask first area, the through area spreads in a gapless manner, and
in the mask second area, the through area includes two or more through lines located in the mask second area, each of the through lines including an end connected to the mask first area.

An eleventh aspect of the present disclosure may be directed to the group of masks according to the tenth aspect, wherein the cell may include cell contours including cell first and second sides that are opposite to each other in a mask first direction and cell third and fourth sides that are opposite to each other in a mask second direction intersecting the mask first direction. the through area may spread along the cell first side, the cell second side, and the cell third side in the mask first area.

A twelfth aspect of the present disclosure may be directed to the group of masks according to the eleventh aspect, wherein the mask second area may be in contact with the cell fourth side.

A thirteenth aspect of the present disclosure may be directed to the group of masks according to each of the tenth to twelfth aspects, wherein each of the through lines may include a first through section and a second through section connected to the first through section, the second through section having a width that is smaller than a width of the first through section.

A fourteenth aspect of the present disclosure may be directed to the group of masks according to each of the tenth to thirteenth aspects, wherein the two or more masks may include a first mask including a first wide-area through hole spreading in a gapless manner in the mask first area, and a second mask including two or more second through holes constituting the through lines in the mask second area.

A fifteenth aspect of the present disclosure may be directed to the group of masks according to the fourteenth aspect, wherein the first mask may include two or more first through holes located in the mask second area, the first through holes partially overlapping the second through holes when seen along the direction normal to the masks.

A sixteenth aspect of the present disclosure may be directed to the group of masks according to each of the tenth to fifteenth aspects, wherein in the mask second area, the through area may have an occupancy of 0.9 or lower.

A seventeenth aspect of the present disclosure is directed to a mask including a shielding area and through holes, the mask including a cell including a mask first area and a mask second area when seen along a direction normal to the mask,
wherein
in the mask first area, one of the through holes spreads in a gapless manner, and
the mask second area includes the shielding area and two or more of the through holes, surrounded by the shielding area.

An eighteenth aspect of the present disclosure may be directed to the mask according to the seventeenth aspect, wherein the cell may include cell contours including cell first and second sides that are opposite to each other in a mask first direction and cell third and fourth sides that are opposite to each other in a mask second direction intersecting the mask first direction. The through hole in the mask first area may spread along the cell first side, the cell second side, and the cell third side in the mask first area.

A nineteenth aspect of the present disclosure may be directed to the mask according to the eighteenth aspect, wherein the mask second area may be in contact with the cell fourth side.

A twentieth aspect of the present disclosure is directed to a manufacturing method for an organic device, the method including a second electrode forming step of forming a second electrode on top of an organic layer on top of a first electrode on top of a substrate by using the group of masks according to any one of the tenth to sixteenth aspects,
wherein the second electrode forming step includes
forming a first layer of the second electrode by a vapor deposition method that involves use of the first mask, and
forming a second layer of the second electrode by a vapor deposition method that involves use of the second mask.

An embodiment of the present disclosure is described in detail with reference to the drawings. It should be noted that the embodiment to be described below is one example among embodiments of the present disclosure, and the present disclosure should not be construed only within the limits of these embodiments.

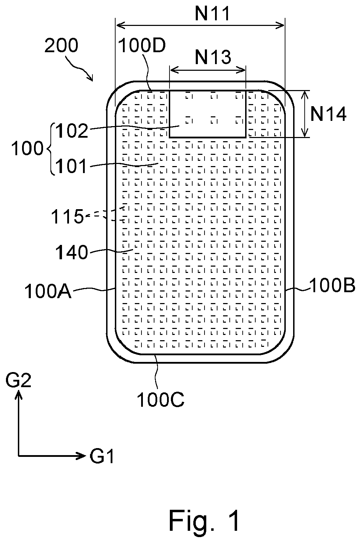

An organic device 200 is described. The organic device 200 includes elements that are formed by using a group of masks of the present embodiment. For example, the after-mentioned second electrode of the organic device 200 is formed by using the group of masks of the present embodiment. Fig. 1 is a plan view showing an example of the organic device 200 as seen along a direction normal to a substrate of the organic device 200. In the following description, a view taken along a direction normal to a surface of a matter, such as a substrate, forming the basis is also referred to as "plan view".

The organic device 200 includes a substrate and a plurality of elements 115 arranged along an in-plane direction of the substrate. The elements 115 are for example pixels. The organic device 200 includes a display area 100 where a picture is displayed. The display area 100 may have contours including a first side 100A, a second side 100B, a third side 100C, and a fourth side 100D. The first side 100A and the second side 100B may be opposite to each other in a first direction G1. The third side 100C and the fourth side 100D may be opposite to each other in a second direction G2. The second direction G2 is a direction intersecting the first direction G1. The second direction G2 may be orthogonal to the first direction G1.

As shown in Fig. 1, the display area 100 may include a first display area 101 and a second display area 102 in plan view. As shown in Fig. 1, the first display area 101 may spread along the first side 100A, the second side 100B, and the third side 100C. For example, the first display area 101 may be in contact with the whole area of the first side 100A, the whole area of the second side 100B, and the whole area of the third side 100C. The first display area 101 may be in partial contact with the fourth side 100D. The second display area 102 may have a smaller area than does the first display area 101. The second display area 102 may be in contact with the fourth side 100D.

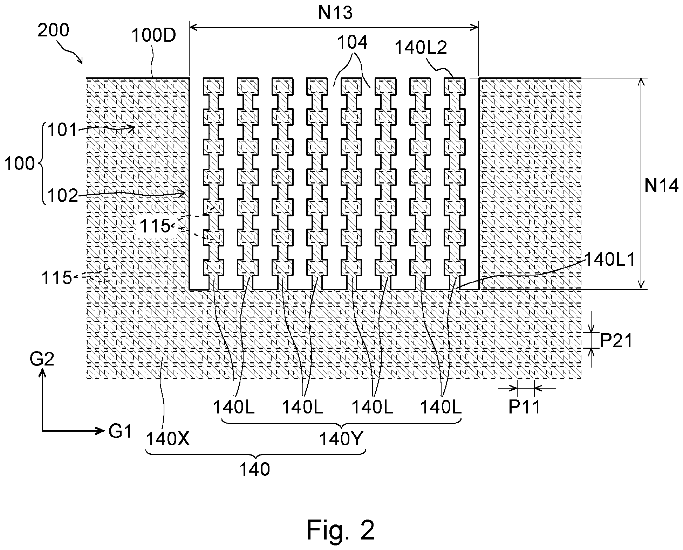

Fig. 2 is an enlarged plan view of the second display area 102 of Fig. 1 and the area therearound. In the first display area 101, the elements 115 may be arranged along two different directions. For example, two or more elements 115 of the first display area 101 may be arranged along the first direction G1 and the second direction G2.

The organic device 200 includes a second electrode 140. The second electrode 140 is located on top of the after-mentioned organic layers 130. The second electrode 140 may be electrically connected to two or more organic layers 130. For example, the second electrode 140 may overlap two or more organic layers 130 in plan view. Part of the second electrode 140 located in the first display area 101 is also referred to as "second electrode 140X". Part of the second electrode 140 located in the second display area 102 is also referred to as "second electrode 140Y".

The second electrode 140X may spread in a gapless manner over the first display area 101. The second electrode 140X is also referred to as "wide-area electrode". The wide-area electrode 140X may spread along the first side 100A, the second side 100B, and the third side 100C. For example, the wide-area electrode 140X may be in contact with the whole area of the first side 100A, the whole area of the second side 100B, and the whole area of the third side 100C. The wide-area electrode 140X may be in partial contact with the fourth side 100D.

As shown in Fig. 2, the second electrode 140Y may include two or more electrode lines 140L arranged in the first direction G1. The electrode lines 140L may extend in the second direction G2. For example, each of the electrode lines 140L may include a first end 140L1 connected to the wide-area electrode 140X in plan view. Each of the electrode lines 140L may include a second end 140L2 located opposite the first end 140L1 in the second direction G2. The second end 140L2 may not be connected to the wide-area electrode 140X in plan view. The second end 140L2 may be located at the fourth side 100D.

The second display area 102 may include a transmissive area 104. The transmissive area 104 does not overlap the second electrode 140 in plan view. For this reason, the transmissive area 104 has a higher transmittance than does an area overlapping the second electrode 140 in plan view. The transmissive area 104 is located, for example, between two electrode lines 140L adjacent to each other in the first direction G1. The area overlapping the second electrode 140 in plan view is also referred to as "non-transmissive area".

The first display area 101 may not include a transmissive area 104.

The second electrode 140X has a first occupancy. The first occupancy is calculated by dividing, by the area of the first display area 101, the total area of the part of the second electrode 140 located in the first display area 101. The first occupancy may for example be 0.95 or higher, 0.98 or higher, 0.99 or higher, or 1.00.

The second electrode 140Y has a second occupancy. The second occupancy is calculated by dividing, by the area of the second display area 102, the total area of the part of the second electrode 140 located in the second display area 102. Since the second display area 102 includes the transmissive area 104, the second occupancy is lower than the first occupancy.

The ratio of the second occupancy to the first occupancy may for example be 0.2 or higher, 0.3 or higher, or 0.4 or higher. The ratio of the second occupancy to the first occupancy may for example be 0.6 or lower, 0.7 or lower, or 0.8 or lower. The ratio of the second occupancy to the first occupancy may fall within a range defined by a first group consisting of 0.2, 0.3, and 0.4 and/or a second group consisting of 0.6, 0.7, and 0.8. The ratio of the second occupancy to the first occupancy may fall within a range defined by a combination of any one of the values included in the aforementioned first group and any one of the values included in the aforementioned second group. The ratio of the second occupancy to the first occupancy may fall within a range defined by a combination of any two of the values included in the aforementioned first group. The ratio of the second occupancy to the first occupancy may fall within a range defined by a combination of any two of the values included in the aforementioned second group. For example, the ratio of the second occupancy to the first occupancy may be 0.2 or higher and 0.8 or lower, 0.2 or higher and 0.7 or lower, 0.2 or higher and 0.6 or lower, 0.2 or higher and 0.4 or lower, 0.2 or higher and 0.3 or lower, 0.3 or higher and 0.8 or lower, 0.3 or higher and 0.7 or lower, 0.3 or higher and 0.6 or lower, 0.3 or higher and 0.4 or lower, 0.4 or higher and 0.8 or lower, 0.4 or higher and 0.7 or lower, 0.4 or higher and 0.6 or lower, 0.6 or higher and 0.8 or lower, 0.6 or higher and 0.7 or lower, or 0.7 or higher and 0.8 or lower.

The transmittance of the non-transmissive area is also referred to as "first transmittance TR1". The transmittance of the transmissive area 104 is also referred to as "second transmittance TR2". Since the transmissive area 104 does not include a second electrode 140Y, the second transmittance TR2 is higher than the first transmittance TR1. For this reason, in the second display area 102, which includes the transmissive area 104, light having arrived at the organic device 200 can pass through the transmissive area 104 and arrive at an optical component or other components on a back side of the substrate. The optical component is a component, such as a camera, that achieves some sort of function by detecting light. Meanwhile, the second display area 102 also includes the non-transmissive area. That is, the second display area 102 includes the second electrode 140Y and elements 115 overlapping the second electrode 140Y. In a case where the elements 115 are pixels, a picture can be displayed on the second display area 102. In this way, the second display area 102 can detect light and display a picture. The function of the second display area 102 that is achieved by detecting light is for example a sensor such as a camera, a fingerprint sensor, or a face authentication sensor. The higher the second transmittance TR2 of the transmissive area 104 of the second display area 102 is and the lower the second occupancy is, the larger amount of light the sensor becomes able to receive.

In a case where either the dimensions of the non-transmissive area in the first direction G1 and the second direction G2 or the dimensions of the transmissive area 104 in the first direction G1 and the second direction G2 are 1 mm or smaller, the first transmittance TR1 and the second transmittance TR2 are measured using a microspectrophotometer. As a microspectrophotometer, any microspectrophotometer that includes an Olympus Corporation's OSP-SP200 can measure a transmittance in a visible range of 380 nm or higher to 780 nm or lower. Quartz is used as a reference. Results of measurement at 550 nm are used as the first transmittance TR1 and the second transmittance TR2.

In a case where either the dimensions of the non-transmissive area in the first direction G1 and the second direction G2 or the dimensions of the transmissive area 104 in the first direction G1 and the second direction G2 are larger than 1 mm, the first transmittance TR1 and the second transmittance TR2 are measured using a spectrophotometer. As a spectrophotometer, a Shimadzu Corporation's ultraviolet-visible spectrophotometer UV-2600i is used. The transmittance of an area with the dimensions 1 mm or larger can be measured by attaching a micro beam lens unit to the spectrophotometer. Atmospheric air is used as a reference. Results of measurement at 550 nm are used as the first transmittance TR1 and the second transmittance TR2.

TR2/TR1, which is the ratio of the second transmittance TR2 to the first transmittance TR1, may for example be 1.2 or higher, 1.5 or higher, or 1.8 or higher. TR2/TR1 may for example be 2 or lower, 3 or lower, or 4 or lower. TR2/TR1 may fall within a range defined by a first group consisting of 1.2, 1.5, and 1.8 and/or a second group consisting of 2, 3, and 4. TR2/TR1 may fall within a range defined by a combination of any one of the values included in the aforementioned first group and any one of the values included in the aforementioned second group. TR2/TR1 may fall within a range defined by a combination of any two of the values included in the aforementioned first group. TR2/TR1 may fall within a range defined by a combination of any two of the values included in the aforementioned second group. TR2/TR1 may for example be 1.2 or higher and 4 or lower, 1.2 or higher and 3 or lower, 1.2 or higher and 2 or lower, 1.2 or higher and 1.8 or lower, 1.2 or higher and 1.5 or lower, 1.5 or higher and 4 or lower, 1.5 or higher and 3 or lower, 1.5 or higher and 2 or lower, 1.5 or higher and 1.8 or lower, 1.8 or higher and 4 or lower, 1.8 or higher and 3 or lower, 1.8 or higher and 2 or lower, 2 or higher and 4 or lower, 2 or higher and 3 or lower, or 3 or higher and 4 or lower.

The second display area 102 has a dimension N13 in the first direction G1, and has a dimension N14 in the second direction G2. As shown in Fig. 2, outer edges of the second display area 102 in the first direction G1 may be defined by the transmissive area 104. As shown in Fig. 2, outer edges of the second display area 102 in the second direction G2 may be defined by the first and second ends 140L1 and 140L2 of the electrode lines 140L.

The dimension N13 may for example be 1.0 mm or larger, 3.0 mm or larger, or 5.0 mm or larger. The dimension N13 may for example be 10.0 mm or smaller, 20.0 mm or smaller, or 30.0 mm or smaller. The dimension N13 may fall within a range defined by a first group consisting of 1.0 mm, 3.0 mm, and 5.0 mm and/or a second group consisting of 10.0 mm, 20.0 mm, and 30.0 mm. The dimension N13 may fall within a range defined by a combination of any one of the values included in the aforementioned first group and any one of the values included in the aforementioned second group. The dimension N13 may fall within a range defined by a combination of any two of the values included in the aforementioned first group. The dimension N13 may fall within a range defined by a combination of any two of the values included in the aforementioned second group. The dimension N13 may for example be 1.0 mm or larger and 30.0 mm or smaller, 1.0 mm or larger and 20.0 mm or smaller, 1.0 mm or larger and 10.0 mm or smaller, 1.0 mm or larger and 5.0 mm or smaller, 1.0 mm or larger and 3.0 mm or smaller, 3.0 mm or larger and 30.0 mm or smaller, 3.0 mm or larger and 20.0 mm or smaller, 3.0 mm or larger and 10.0 mm or smaller, 3.0 mm or larger and 5.0 mm or smaller, 5.0 mm or larger and 30.0 mm or smaller, 5.0 mm or larger and 20.0 mm or smaller, 5.0 mm or larger and 10.0 mm or smaller, 10.0 mm or larger and 30.0 mm or smaller, 10.0 mm or larger and 20.0 mm or smaller, or 20.0 mm or larger and 30.0 mm or smaller.

The dimension N14 may be substantially equal to the dimension N13. The dimension N14 may be smaller than or equal to the dimension N13. N14/N13, which is the ratio of the dimension N14 to the dimension N13, may for example be 0.10 or higher, 0.20 or higher, 0.30 or higher, or 0.40 or higher. N14/N13 may for example be 0.50 or lower, 0.80 or lower, 0.99 or lower, or 1.10 or lower. N14/N13 may fall within a range defined by a first group consisting of 0.10, 0.20, 0.30, and 0.40 and/or a second group consisting of 0.50, 0.80, 0.99, and 1.10. N14/N13 may fall within a range defined by a combination of any one of the values included in the aforementioned first group and any one of the values included in the aforementioned second group. N14/N13 may fall within a range defined by a combination of any two of the values included in the aforementioned first group. N14/N13 may fall within a range defined by a combination of any two of the values included in the aforementioned second group. N14/N13 may for example be 0.10 or higher and 1.10 or lower, 0.10 or higher and 0.99 or lower, 0.10 or higher and 0.80 or lower, 0.10 or higher and 0.50 or lower, 0.10 or higher and 0.40 or lower, 0.10 or higher and 0.30 or lower, 0.10 or higher and 0.20 or lower, 0.20 or higher and 1.10 or lower, 0.20 or higher and 0.99 or lower, 0.20 or higher and 0.80 or lower, 0.20 or higher and 0.50 or lower, 0.20 or higher and 0.40 or lower, 0.20 or higher and 0.30 or lower, 0.30 or higher and 1.10 or lower, 0.30 or higher and 0.99 or lower, 0.30 or higher and 0.80 or lower, 0.30 or higher and 0.50 or lower, 0.30 or higher and 0.40 or lower, 0.40 or higher and 1.10 or lower, 0.40 or higher and 0.99 or lower, 0.40 or higher and 0.80 or lower, 0.40 or higher and 0.50 or lower, 0.50 or higher and 1.10 or lower, 0.50 or higher and 0.99 or lower, 0.50 or higher and 0.80 or lower, 0.80 or higher and 1.10 or lower, 0.80 or higher and 0.99 or lower, or 0.99 or higher and 1.10 or lower.

As shown in Fig. 1, the display area 100 has a dimension N11 in the first direction G1. Outer edges of the display area 100 in the first direction G1 may be defined by the second electrode 140.

N13/N11, which is the ratio of the dimension N13 to the dimension N11, may for example be 0.05 or higher, 0.10 or higher, 0.20 or higher, or 0.30 or higher. N13/N11 may for example be 0.40 or lower, 0.50 or lower, 0.60 or lower, or 0.80 or lower. N13/N11 may fall within a range defined by a first group consisting of 0.05, 0.10, 0.20, and 0.30 and/or a second group consisting of 0.40, 0.50, 0.60, and 0.80. N13/N11 may fall within a range defined by a combination of any one of the values included in the aforementioned first group and any one of the values included in the aforementioned second group. N13/N11 may fall within a range defined by a combination of any two of the values included in the aforementioned first group. N13/N11 may fall within a range defined by a combination of any two of the values included in the aforementioned second group. N13/N11 may for example be 0.05 or higher and 0.80 or lower, 0.05 or higher and 0.60 or lower, 0.05 or higher and 0.50 or lower, 0.05 or higher and 0.40 or lower, 0.05 or higher and 0.30 or lower, 0.05 or higher and 0.20 or lower, 0.05 or higher and 0.10 or lower, 0.10 or higher and 0.80 or lower, 0.10 or higher and 0.60 or lower, 0.10 or higher and 0.50 or lower, 0.10 or higher and 0.40 or lower, 0.10 or higher and 0.30 or lower, 0.10 or higher and 0.20 or lower, 0.20 or higher and 0.80 or lower, 0.20 or higher and 0.60 or lower, 0.20 or higher and 0.50 or lower, 0.20 or higher and 0.40 or lower, 0.20 or higher and 0.30 or lower, 0.30 or higher and 0.80 or lower, 0.30 or higher and 0.60 or lower, 0.30 or higher and 0.50 or lower, 0.30 or higher and 0.40 or lower, 0.40 or higher and 0.80 or lower, 0.40 or higher and 0.60 or lower, 0.40 or higher and 0.50 or lower, 0.50 or higher and 0.80 or lower, 0.50 or higher and 0.60 or lower, or 0.60 or higher and 0.80 or lower.

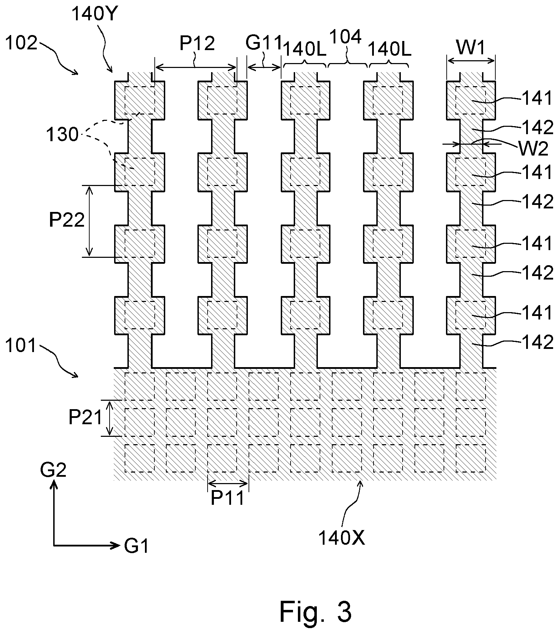

Fig. 3 is a partially-enlarged plan view showing the first display area 101 and the second display area 102 of Fig. 2. The second electrode 140X and the second electrode 140Y may both overlap organic layers 130 in plan view. Each of the organic layers 130 is a constituent element of the corresponding one of the elements 115.

The first display area 101 includes organic layers 130 distributed at a first density PD1. The second display area 102 includes organic layers 130 distributed at a second density PD2. The second density PD2 is lower than the first density PD1. PD2/PD1, which is the ratio of the second density PD2 to the first density PD1, may for example be 0.1 or higher, 0.2 or higher, or 0.4 or higher. PD2/PD1 may for example be 0.6 or lower, 0.8 or lower, or 0.9 or lower. PD2/PD1 may fall within a range defined by a first group consisting of 0.1, 0.2, and 0.4 and/or a second group consisting of 0.6, 0.8, and 0.9. PD2/PD1 may fall within a range defined by a combination of any one of the values included in the aforementioned first group and any one of the values included in the aforementioned second group. PD2/PD1 may fall within a range defined by a combination of any two of the values included in the aforementioned first group. PD2/PD1 may fall within a range defined by a combination of any two of the values included in the aforementioned second group. PD2/PD1 may for example be 0.1 or higher and 0.9 or lower, 0.1 or higher and 0.8 or lower, 0.1 or higher and 0.6 or lower, 0.1 or higher and 0.4 or lower, 0.1 or higher and 0.2 or lower, 0.2 or higher and 0.9 or lower, 0.2 or higher and 0.8 or lower, 0.2 or higher and 0.6 or lower, 0.2 or higher and 0.4 or lower, 0.4 or higher and 0.9 or lower, 0.4 or higher and 0.8 or lower, 0.4 or higher and 0.6 or lower, 0.6 or higher and 0.9 or lower, 0.6 or higher and 0.8 or lower, or 0.8 or higher and 0.9 or lower.

In the first display area 101, the organic layers 130 may be arranged along two different directions. For example, the organic layers 130 may be arranged at an eleventh pitch P11 along the first direction G1. In the second display area 102, the organic layers 130 may be arranged at a twelfth pitch P12 along the first direction G1. The twelfth pitch P12 may be greater than the eleventh pitch P11.

The ratio of the twelfth pitch P12 to the eleventh pitch P11 may for example be 1.1 or higher, 1.3 or higher, or 1.5 or higher. P12/P11, which is the ratio of the twelfth pitch P12 to the eleventh pitch P11, may for example be 2.0 or lower, 3.0 or lower, or 4.0 or lower. P12/P11 may fall within a range defined by a first group consisting of 1.1, 1.3, and 1.5 and/or a second group consisting of 2.0, 3.0, and 4.0. P12/P11 may fall within a range defined by a combination of any one of the values included in the aforementioned first group and any one of the values included in the aforementioned second group. P12/P11 may fall within a range defined by a combination of any two of the values included in the aforementioned first group. P12/P11 may fall within a range defined by a combination of any two of the values included in the aforementioned second group. P12/P11 may for example be 1.1 or higher and 4.0 or lower, 1.1 or higher and 3.0 or lower, 1.1 or higher and 2.0 or lower, 1.1 or higher and 1.5 or lower, 1.1 or higher and 1.3 or lower, 1.3 or higher and 4.0 or lower, 1.3 or higher and 3.0 or lower, 1.3 or higher and 2.0 or lower, 1.3 or higher and 1.5 or lower, 1.5 or higher and 4.0 or lower, 1.5 or higher and 3.0 or lower, 1.5 or higher and 2.0 or lower, 2.0 or higher and 4.0 or lower, 2.0 or higher and 3.0 or lower, or 3.0 or higher and 4.0 or lower. In a case where P12/P11 is low, the difference between the first density PD1 and the second density PD2 is small. This makes it possible to reduce the occurrence of a visual difference between the first display area 101 and the second display area 102.

In the first display area 101, the organic layers 130 may be arranged at a twenty-first pitch P21 along the second direction G2. In the second display area 102, the organic layers 130 may be arranged at a twenty-second pitch P22 along the second direction G2. The twenty-second pitch P22 may be greater than the twenty-first pitch P21. As a range of P22/P21, which is the ratio of the twenty-second pitch P22 to the twenty-first pitch P21, the aforementioned "range of P12/P11" can be adopted.

PD2/PD1, which is the ratio of the second density PD2 to the first density PD1, may be calculated on the basis of the eleventh pitch P11, the twelfth pitch P12, the twenty-first pitch P21, and the twenty-second pitch P22. For example, PD2/PD1 may be (P11 × P21)/(P12 × P22).

As shown in Fig. 3, the wide-area electrode 140X may overlap two or more organic layers 130 arranged in the first direction G1 and two or more organic layers 130 arranged in the second direction G2. The wide-area electrode 140X may overlap 95% or more, 98% or more, or 99% or more of the organic layers 130 located in the first display area 101. The wide-area electrode 140X may overlap all organic layers 130 located in the first display area 101.

As shown in Fig. 3, one electrode line 140L may overlap, in plan view, two or more organic layers 130 arranged along the second direction G2.

The sign "G11" denotes a gap between two electrode lines 140L adjacent to each other in the first direction G1. The gap G11 may be defined according to the second transmittance TR2 of the transmissive area 104. The gap G11 may be defined with reference to the eleventh pitch P11 between organic layers 130.

G11/P11, which is the ratio of the gap G11 to the eleventh pitch P11, may for example be 0.3 or higher, 0.5 or higher, or 1.0 or higher. G11/P11 may for example be 1.5 or lower, 2.0 or lower, or 3.0 or lower. G11/P11 may fall within a range defined by a first group consisting of 0.3, 0.5, and 1.0 and/or a second group consisting of 1.5, 2.0, and 3.0. G11/P11 may fall within a range defined by a combination of any one of the values included in the aforementioned first group and any one of the values included in the aforementioned second group. G11/P11 may fall within a range defined by a combination of any two of the values included in the aforementioned first group. G11/P11 may fall within a range defined by a combination of any two of the values included in the aforementioned second group. G11/P11 may for example be 0.3 or higher and 3.0 or lower, 0.3 or higher and 2.0 or lower, 0.3 or higher and 1.5 or lower, 0.3 or higher and 1.0 or lower, 0.3 or higher and 0.5 or lower, 0.5 or higher and 3.0 or lower, 0.5 or higher and 2.0 or lower, 0.5 or higher and 1.5 or lower, 0.5 or higher and 1.0 or lower, 1.0 or higher and 3.0 or lower, 1.0 or higher and 2.0 or lower, 1.0 or higher and 1.5 or lower, 1.5 or higher and 3.0 or lower, 1.5 or higher and 2.0 or lower, or 2.0 or higher and 3.0 or lower.

The gap G11 may for example be 50 µm or larger, 100 µm or larger, or 150 µm or larger. The gap G11 may for example be 200 µm or smaller, 250 µm or smaller, or 300 µm or smaller. The gap G11 may fall within a range defined by a first group consisting of 50 µm, 100 µm, and 150 µm and/or a second group consisting of 200 µm, 250 µm, and 300 µm. The gap G11 may fall within a range defined by a combination of any one of the values included in the aforementioned first group and any one of the values included in the aforementioned second group. The gap G11 may fall within a range defined by a combination of any two of the values included in the aforementioned first group. The gap G11 may fall within a range defined by a combination of any two of the values included in the aforementioned second group. The gap G11 may for example be 50 µm or larger and 300 µm or smaller, 50 µm or larger and 250 µm or smaller, 50 µm or larger and 200 µm or smaller, 50 µm or larger and 150 µm or smaller, 50 µm or larger and 100 µm or smaller, 100 µm or larger and 300 µm or smaller, 100 µm or larger and 250 µm or smaller, 100 µm or larger and 200 µm or smaller, 100 µm or larger and 150 µm or smaller, 150 µm or larger and 300 µm or smaller, 150 µm or larger and 250 µm or smaller, 150 µm or larger and 200 µm or smaller, 200 µm or larger and 300 µm or smaller, 200 µm or larger and 250 µm or smaller, or 250 µm or larger and 300 µm or smaller.

As shown in Fig. 3, each of the electrode lines 140L may include a pixel section 141 and a connection section 142. The pixel section 141 may overlap an organic layer 130 in plan view. The connection section 142 may be connected to the pixel section 141. The connection section 142 may not overlap an organic layer 130 in plan view. The pixel section 141 and the connection section 142 may be alternately arranged in the second direction G2.

The pixel section 141 has a first width W1. The connection section 142 has a second width W2. The first width W1 and the second width W2 are a dimension of the pixel section 141 and a dimension of the connection section 142, respectively, in a direction orthogonal to a direction in which the pixel section 141 and the connection section 142 are arranged. The second width W2 may be smaller than the first width W1. W2/W1, which is the ratio of the second width W2 to the first width W1, may for example be 0.1 or higher, 0.2 or higher, or 0.3 or higher. W2/W1 may for example be 0.7 or lower, 0.8 or lower, or 0.9 or lower. W2/W1 may fall within a range defined by a first group consisting of 0.1, 0.2, and 0.3 and/or a second group consisting of 0.7, 0.8, and 0.9. W2/W1 may fall within a range defined by a combination of any one of the values included in the aforementioned first group and any one of the values included in the aforementioned second group. W2/W1 may fall within a range defined by a combination of any two of the values included in the aforementioned first group. W2/W1 may fall within a range defined by a combination of any two of the values included in the aforementioned second group. W2/W1 may for example be 0.1 or higher and 0.9 or lower, 0.1 or higher and 0.8 or lower, 0.1 or higher and 0.7 or lower, 0.1 or higher and 0.3 or lower, 0.1 or higher and 0.2 or lower, 0.2 or higher and 0.9 or lower, 0.2 or higher and 0.8 or lower, 0.2 or higher and 0.7 or lower, 0.2 or higher and 0.3 or lower, 0.3 or higher and 0.9 or lower, 0.3 or higher and 0.8 or lower, 0.3 or higher and 0.7 or lower, 0.7 or higher and 0.9 or lower, 0.7 or higher and 0.8 or lower, or 0.8 or higher and 0.9 or lower.

Although not illustrated, the second width W2 may be substantially equal to the first width W1. For example, W2/W1 may be 0.9 or higher and 1.1 or lower.

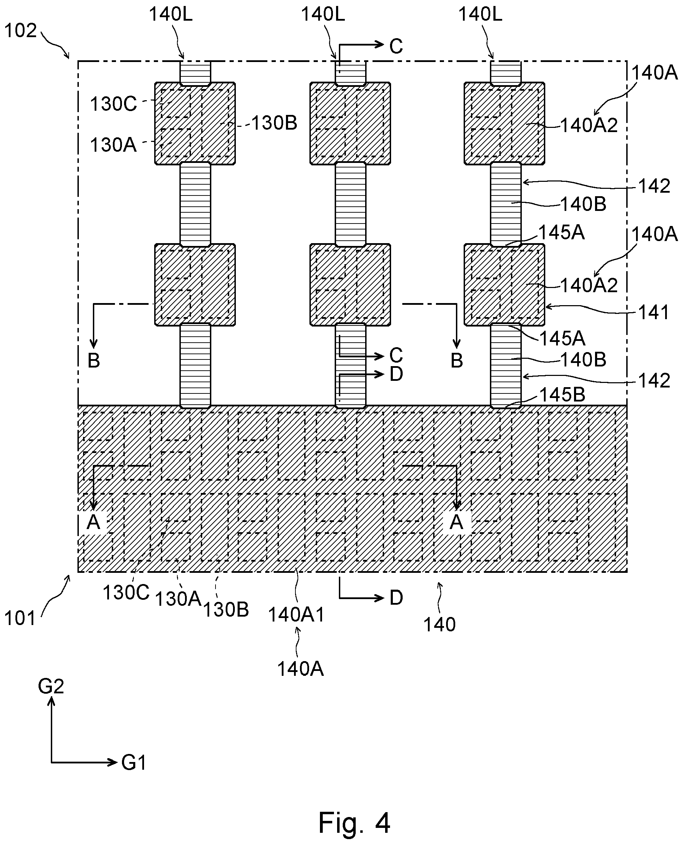

A layer configuration of the second electrode 140 is described. Fig. 4 is a partially-enlarged plan view showing the second electrode 140 of Fig. 3.

The second electrode 140 may include a plurality of layers. For example, the second electrode 140 may include a first layer 140A and a second layer 140B. The first layer 140A and the second layer 140B are layers that are formed by vapor deposition methods that involve the use of the after-mentioned first and second masks 50A and 50B, respectively. The second layer 140B may partially overlap the first layer 140A. An area where the plurality of layers of the second electrode 140 overlap in plan view is also referred to as "electrode overlap area 145".

The electrode overlap area 145 may include a first overlap area 145A. The first overlap area 145A is an area where a plurality of layers of the second electrode 140 located in the second display area 102 overlap. In the example shown in Fig. 4, the first overlap area 145A includes parts of the first and second layers 140A and 140B located in the second display area 102.

The electrode overlap area 145 may include a second overlap area 145B. The second overlap area 145B is an area where at least one layer of the second electrode 140 located in the first display area 101 and at least one layer of the second electrode 140 spreading from the second display area 102 to the first display area 101 overlap each other. In the example shown in Fig. 4, the second overlap area 145B includes part of the first layer 140A located in the first display area 101 and part of the second layer 140B spreading from the second display area 102 to the first display area 101.

The following description uses the term and sign "electrode overlap area 145" to describe a configuration common to the first overlap area 145A and the second overlap area 145B.

The first layer 140A may constitute the wide-area electrode 140X. A portion of the first layer 140A constituting the wide-area electrode 140X is denoted by the sign "140A1".

The first layer 140A may constitute the pixel sections 141. Portions of the first layer 140A constituting the pixel sections 141 are each denoted by the sign "140A2".

The second layer 140B may constitute the connection sections 142. The second layer 140B may include two ends overlapping first layers 140A2. The second layer 140B may include one end overlapping the first layer 140A1 and one end overlapping a first layer 140A2.

The area of the electrode overlap area 145 may be smaller than the area of the second layer 140B. The ratio of the area of the electrode overlap area 145 to the area of the second layer 140B may for example be 0.02 or higher, 0.05 or higher, or 0.10 or higher. The ratio of the area of the electrode overlap area 145 to the area of the second layer 140B may for example be 0.20 or lower, 0.30 or lower, or 0.40 or lower. The ratio of the area of the electrode overlap area 145 to the area of the second layer 140B may fall within a range defined by a first group consisting of 0.02, 0.05, and 0.10 and/or a second group consisting of 0.20, 0.30, and 0.40. The ratio of the area of the electrode overlap area 145 to the area of the second layer 140B may fall within a range defined by a combination of any one of the values included in the aforementioned first group and any one of the values included in the aforementioned second group. The ratio of the area of the electrode overlap area 145 to the area of the second layer 140B may fall within a range defined by a combination of any two of the values included in the aforementioned first group. The ratio of the area of the electrode overlap area 145 to the area of the second layer 140B may fall within a range defined by a combination of any two of the values included in the aforementioned second group. The ratio of the area of the electrode overlap area 145 to the area of the second layer 140B may for example be 0.02 or higher and 0.40 or lower, 0.02 or higher and 0.30 or lower, 0.02 or higher and 0.20 or lower, 0.02 or higher and 0.10 or lower, 0.02 or higher and 0.05 or lower, 0.05 or higher and 0.40 or lower, 0.05 or higher and 0.30 or lower, 0.05 or higher and 0.20 or lower, 0.05 or higher and 0.10 or lower, 0.10 or higher and 0.40 or lower, 0.10 or higher and 0.30 or lower, 0.10 or higher and 0.20 or lower, 0.20 or higher and 0.40 or lower, 0.20 or higher and 0.30 or lower, or 0.30 or higher and 0.40 or lower.

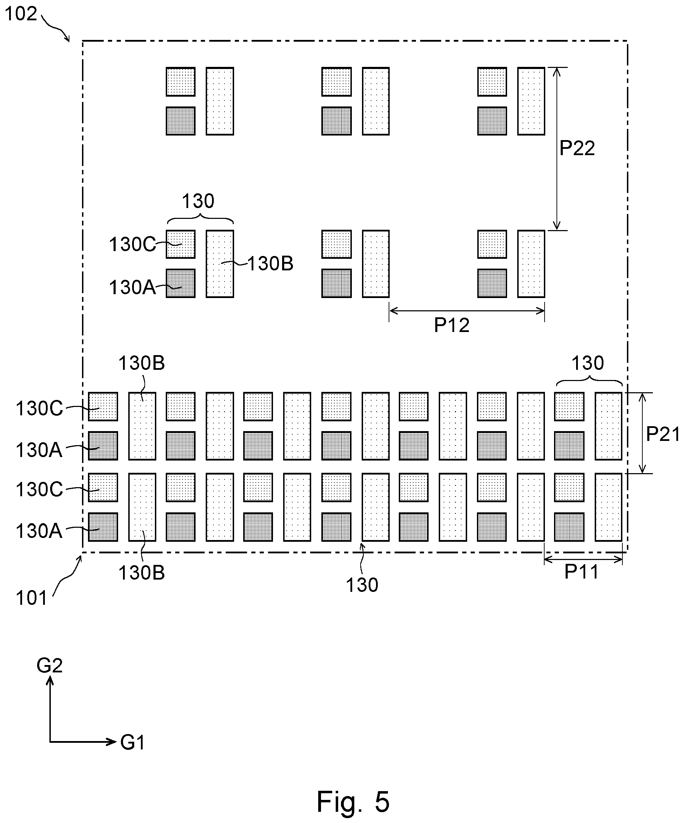

Fig. 5 is a plan view showing the organic device 200 with the second electrode 140 removed therefrom in Fig. 4. Each of the organic layers 130 may include a first organic layer 130A, a second organic layer 130B, and a third organic layer 130C. The first organic layer 130A, the second organic layer 130B, and the third organic layer 130C are for example a red luminescent layer, a blue luminescent layer, and a green luminescent layer. Organic layers, such as the red luminescent layer, the blue luminescent layer, and the green luminescent layer, that emit particular colors of light are also referred to as "sub-organic layers". The following description uses the term and sign "organic layer 130" to describe an organic layer configuration common to the first organic layer 130A, the second organic layer 130B, and the third organic layer 130C.

As shown in Figs. 4 and 5, one first layer 140A2 may overlap two or more sub-organic layers. Although not illustrated, one first layer 140A2 may overlap one sub-organic layer.

The arrangement of the second electrode 140 and the organic layers 130 in plan view is detected by observing the organic device 200 with a digital microscope. The digital microscope has a magnification of ×500. On the basis of a result of the detection, the aforementioned occupancies, areas, dimensions, pitches, gaps, or other values can be calculated. In a case where the organic device 200 has a cover such as a glass cover, the second electrode 140 and the organic layers 130 may be observed after the cover has been removed by detaching or breaking the cover.

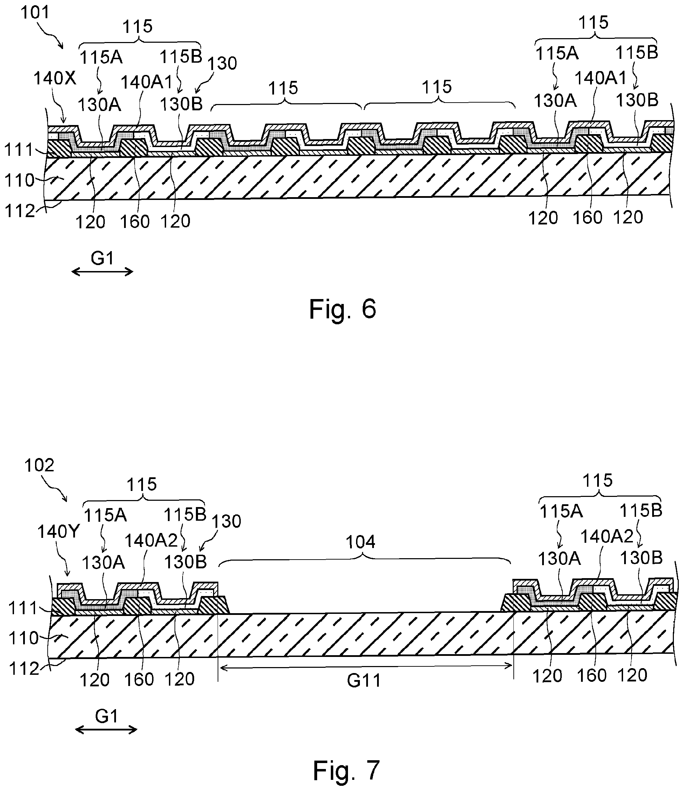

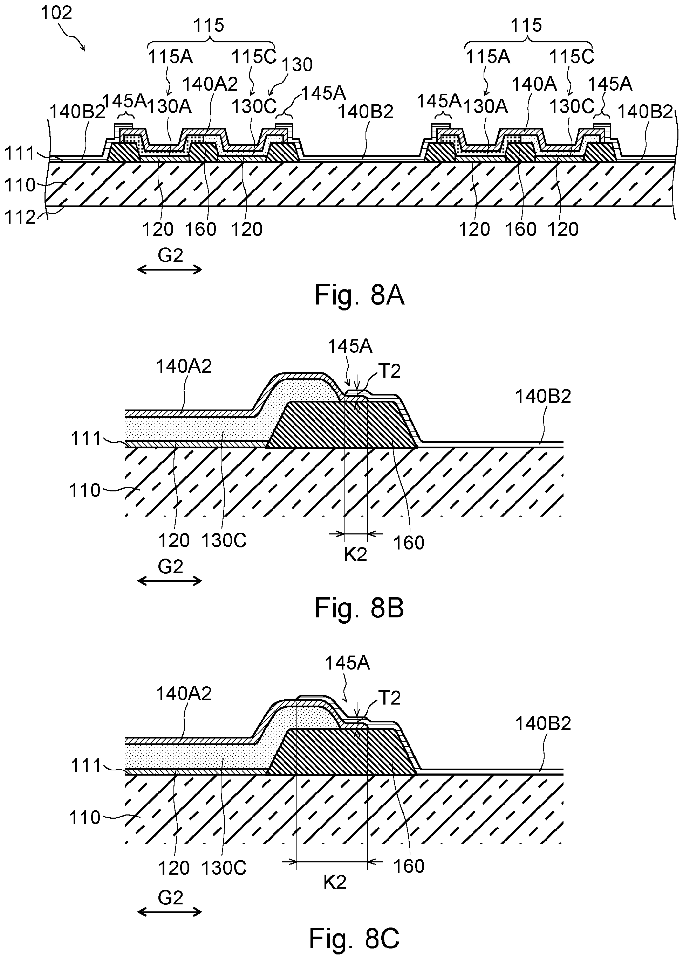

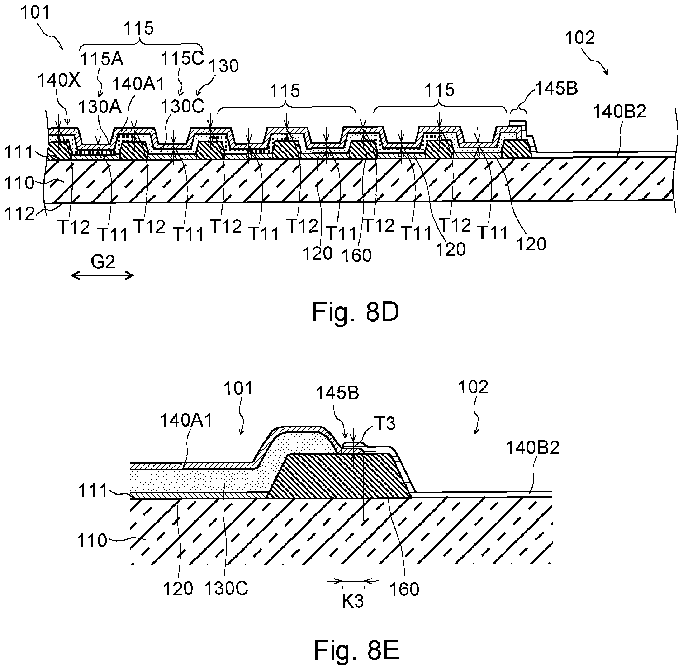

Next, an example of a layer configuration of the organic device 200 is described. Fig. 6 is a cross-sectional view of the organic device 200 as taken along line A-A in Fig. 4. Fig. 7 is a cross-sectional view of the organic device 200 as taken along line B-B in Fig. 4. Fig. 8A is a cross-sectional view of the organic device 200 as taken along line C-C in Fig. 4. Fig. 8D is a cross-sectional view of the organic device 200 as taken along line D-D in Fig. 4.

The organic device 200 includes a substrate 110 and elements 115 located on top of the substrate 110. Each of the element 115 may include a first electrode 120, an organic layer 130 located on top of the first electrode 120, and part of the second electrode 140 located on top of the organic layer 130.

The organic device 200 may include an insulating layer 160 located between two first electrodes 120 adjacent to each other in plan view. The insulating layer 160 contains, for example, polyimide. The insulating layer 160 may overlap an end of a first electrode 120.

The organic device 200 may be of an active matrix type. For example, although not illustrated, the organic device 200 may include a switch. The switch is electrically connected to every one of a plurality of the elements 115. The switch is for example a transistor. The switch can control the turning on and turning off of a voltage or an electric current to the corresponding element 115.

As shown in Fig. 6, the wide-area electrode 140X of the first display area 101 may be constituted by one layer, e.g. a first layer 140A1. The wide-area electrode 140X may not include an electrode overlap area 145. As shown in Figs. 8A and 8D, the electrode overlap area 145 includes the plurality of layers of the second electrode 140. For this reason, the electrode overlap area 145 has a lower transmittance than does one layer of the second electrode 140. In a case where the wide-area electrode 140X does not include an electrode overlap area 145, the occurrence of unevenness in intensity of light in the first display area 101 can be reduced.

As shown in Fig. 7, the second display area 102 includes the transmissive area 104. As mentioned above, the transmissive area 104 does not overlap the second electrode 140 in plan view. The transmissive area 104 may not overlap an organic layer 130.

As shown in Figs. 8A and 8D, the electrode overlap area 145 may overlap the insulating layer 160 in plan view. For example, in a plan view, the electrode overlap area 145 may be surrounded by the contours of the insulating layer 160. This makes it possible to reduce the occurrence of unevenness in intensity of light due to light having passed through the electrode overlap area 145.

A first overlap area 145A is described in detail. Fig. 8B is a cross-sectional view showing an example of a first overlap area 145A. As shown in Fig. 8B, the first overlap area 145A may not overlap an organic layer 130.

The first overlap area 145A has a thickness T2. The thickness T2 is the sum of the thicknesses of a plurality of layers constituting the first overlap area 145A. In the example shown in Fig. 8B, the thickness T2 is the sum of the thickness of a first layer 140A2 and the thickness of a second layer 140B2.

The thickness T2 of the first overlap area 145A may be greater than the thickness T1 of the wide-area electrode 140X. This makes it possible to reduce the electric resistance of the electrode line 140L. The thickness T1 of the wide-area electrode 140X is the after-mentioned first average thickness µ1. The thickness T2 is calculated by averaging the thicknesses of ten first overlap areas 145A arranged from the first end 140L1 to the second end 140L2. The thickness of one first overlap area 145A is the maximum value of the thickness of a first overlap area 145A that appears in a cross-sectional view.

T2/T1, which is the ratio of the thickness T2 to the thickness T1, may for example be 1.05 or higher, 1.10 or higher, or 1.20 or higher. T2/T1 may for example be 2.50 or lower, 2.00 or lower, or 1.50 or lower. T2/T1 may fall within a range defined by a first group consisting of 1.05, 1.10, and 1.20 and/or a second group consisting of 2.50, 2.00, and 1.50. T2/T1 may fall within a range defined by a combination of any one of the values included in the aforementioned first group and any one of the values included in the aforementioned second group. T2/T1 may fall within a range defined by a combination of any two of the values included in the aforementioned first group. T2/T1 may fall within a range defined by a combination of any two of the values included in the aforementioned second group. T2/T1 may for example be 1.05 or higher and 1.50 or lower, 1.05 or higher and 2.00 or lower, 1.05 or higher and 2.50 or lower, 1.05 or higher and 1.20 or lower, 1.05 or higher and 1.10 or lower, 1.10 or higher and 1.50 or lower, 1.10 or higher and 2.00 or lower, 1.10 or higher and 2.50 or lower, 1.10 or higher and 1.20 or lower, 1.20 or higher and 1.50 or lower, 1.20 or higher and 2.00 or lower, 1.20 or higher and 2.50 or lower, 2.50 or higher and 1.50 or lower, 2.50 or higher and 2.00 or lower, or 2.00 or higher and 1.50 or lower.

Fig. 8C is a cross-sectional view showing another example of a first overlap area 145A. As shown in Fig. 8C, the first overlap area 145A may overlap an organic layer 130. As shown in Fig. 8C, part of the first overlap area 145A may overlap an organic layer 130. Although not illustrated, the whole of the first overlap area 145A may overlap an organic layer 130.

The first overlap area 145A has a dimension K2 in the second direction G2. The dimension K2 may for example be 1.0 µm or larger, 3.0 µm or larger, or 5.0 µm or larger. The dimension K2 may for example be 10.0 µm or smaller, 20.0 µm or smaller, or 50.0 µm or smaller. The dimension K2 may fall within a range defined by a first group consisting of 1.0 µm, 3.0 µm, and 5.0 µm and/or a second group consisting of 10.0 µm, 20.0 µm, and 50.0 µm. The dimension K2 may fall within a range defined by a combination of any one of the values included in the aforementioned first group and any one of the values included in the aforementioned second group. The dimension K2 may fall within a range defined by a combination of any two of the values included in the aforementioned first group. The dimension K2 may fall within a range defined by a combination of any two of the values included in the aforementioned second group. The dimension K2 may for example be 1.0 µm or higher and 50.0 µm or lower, 1.0 µm or higher and 20.0 µm or lower, 1.0 µm or higher and 10.0 µm or lower, 1.0 µm or higher and 5.0 µm or lower, 1.0 µm or higher and 3.0 µm or lower, 3.0 µm or higher and 50.0 µm or lower, 3.0 µm or higher and 20.0 µm or lower, 3.0 µm or higher and 10.0 µm or lower, 3.0 µm or higher and 5.0 µm or lower, 5.0 µm or higher and 50.0 µm or lower, 5.0 µm or higher and 20.0 µm or lower, 5.0 µm or higher and 10.0 µm or lower, 10.0 µm or higher and 50.0 µm or lower, 10.0 µm or higher and 20.0 µm or lower, or 20.0 µm or higher and 50.0 µm or lower.

A second overlap area 145B is described in detail. Fig. 8E is a cross-sectional view showing an example of a second overlap area 145B. As shown in Fig. 8E, the second overlap area 145B may not overlap an organic layer 130. As with the first overlap area 145A shown in Fig. 8C, the second overlap area 145B may overlap an organic layer 130. For example, part of the second overlap area 145B may overlap an organic layer 130. For example, the whole of the second overlap area 145B may overlap an organic layer 130.

The second overlap area 145B has a thickness T3. The thickness T3 is the sum of the thicknesses of a plurality of layers constituting the second overlap area 145B. In the example shown in Fig. 8E, the thickness T3 is the sum of the thickness of a first layer 140A1 and the thickness of a second layer 140B2.

The thickness T3 of the second overlap area 145B may be greater than the thickness T1 of the wide-area electrode 140X. This makes it possible to reduce the connection resistance between the electrode line 140L and the wide-area electrode 140X. The thickness T3 is calculated by averaging the thicknesses of all second overlap areas 145B. The thickness of one second overlap area 145B is the maximum value of the thickness of the one second overlap area 145B that appears in a cross-sectional view. As a range of T3/T1, which is the ratio of the thickness T3 to the thickness T1, the aforementioned "range of T2/T1" can be adopted.

The second overlap area 145B has a dimension K3 in the second direction G2. As a range of the dimension K3, the aforementioned "range of the dimension K2" can be adopted.

The thickness of the wide-area electrode 140X is described. In a case where the wide-area electrode 140X does not include an electrode overlap area 145, the wide-area electrode 140X can have a uniform thickness. For example, a first standard deviation σ1 of the wide-area electrode 140X can be made smaller. This makes it possible to reduce the occurrence of unevenness in intensity of light in the first display area 101.

The first standard deviation σ1 is calculated on the basis of the thicknesses T11 of a plurality of first portions of the wide-area electrode 140X. A first portion is a portion of the wide-area electrode 140X overlapping a first electrode 120 in plan view. As shown in Fig. 8D, the plurality of first portions is arranged along the second direction G2. As shown in Fig. 8D, the plurality of first portions includes one first portion adjacent to the second display area 102 in the second direction G2. Specifically, the plurality of first portions is ten first portions. The thickness T11 of one first portion is measured at a middle position on the first portion in the second direction G2. A standard deviation of the thicknesses T11 of the ten first portions is the first standard deviation σ1. The average of the thicknesses T11 of the ten first portions is also referred to as "first average thickness µ1".

The first average thickness µ1 may for example be 5 nm or greater, 10 nm or greater, 50 nm or greater, or 100 nm or greater. The first average thickness µ1 may for example be 200 nm or less, 500 nm or less, 1 µm or less, or 100 µm or less. The first average thickness µ1 may fall within a range defined by a first group consisting of 5 nm, 10 nm, 50 nm, and 100 nm and/or a second group consisting of 200 nm, 500 nm, 1 µm, and 100 µm. The first average thickness µ1 may fall within a range defined by a combination of any one of the values included in the aforementioned first group and any one of the values included in the aforementioned second group. The first average thickness µ1 may fall within a range defined by a combination of any two of the values included in the aforementioned first group. The first average thickness µ1 may fall within a range defined by a combination of any two of the values included in the aforementioned second group. The first average thickness µ1 may for example be 5 nm or greater and 100 µm or less, 5 nm or greater and 1 µm or less, 5 nm or greater and 500 nm or less, 5 nm or greater and 200 nm or less, 5 nm or greater and 100 nm or less, 5 nm or greater and 50 nm or less, 5 nm or greater and 10 nm or less, 10 nm or greater and 100 µm or less, 10 nm or greater and 1 µm or less, 10 nm or greater and 500 nm or less, 10 nm or greater and 200 nm or less, 10 nm or greater and 100 nm or less, 10 nm or greater and 50 nm or less, 50 nm or greater and 100 µm or less, 50 nm or greater and 1 µm or less, 50 nm or greater and 500 nm or less, 50 nm or greater and 200 nm or less, 50 nm or greater and 100 nm or less, 100 nm or greater and 100 µm or less, 100 nm or greater and 1 µm or less, 100 nm or greater and 500 nm or less, 100 nm or greater and 200 nm or less, 200 nm or greater and 100 µm or less, 200 nm or greater and 1 µm or less, 200 nm or greater and 500 nm or less, 500 nm or greater and 100 µm or less, 500 nm or greater and 1 µm or less, or 1 µm or greater and 100 µm or less.

The first standard deviation σ1 may for example be 1.0 nm or greater, 2.0 nm or greater, 3.0 nm or greater, or 5.0 nm or greater. The first standard deviation σ1 may for example be 10.0 nm or less, 15.0 nm or less, 20.0 nm or less, or 30.0 nm or less. The first standard deviation σ1 may fall within a range defined by a first group consisting of 1.0 nm, 2.0 nm, 3.0 nm, and 5.0 nm and/or a second group consisting of 10.0 nm, 15.0 nm, 20.0 nm, and 30.0 nm. The first standard deviation σ1 may fall within a range defined by a combination of any one of the values included in the aforementioned first group and any one of the values included in the aforementioned second group. The first standard deviation σ1 may fall within a range defined by a combination of any two of the values included in the aforementioned first group. The first standard deviation σ1 may fall within a range defined by a combination of any two of the values included in the aforementioned second group. The first standard deviation σ1 may for example be 1.0 nm or greater and 30.0 nm or less, 1.0 nm or greater and 20.0 nm or less, 1.0 nm or greater and 15.0 nm or less, 1.0 nm or greater and 10.0 nm or less, 1.0 nm or greater and 5.0 nm or less, 1.0 nm or greater and 3.0 nm or less, 1.0 nm or greater and 2.0 nm or less, 2.0 nm or greater and 30.0 nm or less, 2.0 nm or greater and 20.0 nm or less, 2.0 nm or greater and 15.0 nm or less, 2.0 nm or greater and 10.0 nm or less, 2.0 nm or greater and 5.0 nm or less, 2.0 nm or greater and 3.0 nm or less, 3.0 nm or greater and 30.0 nm or less, 3.0 nm or greater and 20.0 nm or less, 3.0 nm or greater and 15.0 nm or less, 3.0 nm or greater and 10.0 nm or less, 3.0 nm or greater and 5.0 nm or less, 5.0 nm or greater and 30.0 nm or less, 5.0 nm or greater and 20.0 nm or less, 5.0 nm or greater and 15.0 nm or less, 5.0 nm or greater and 10.0 nm or less, 10.0 nm or greater and 30.0 nm or less, 10.0 nm or greater and 20.0 nm or less, 10.0 nm or greater and 15.0 nm or less, 15.0 nm or greater and 30.0 nm or less, 15.0 nm or greater and 20.0 nm or less, or 20.0 nm or greater and 30.0 nm or less.

The wide-area electrode 140X may have a second standard deviation σ2 that is small. The second standard deviation σ2 is calculated on the basis of the thicknesses T11 of the plurality of first portions of the wide-area electrode 140X and the thicknesses T12 of a plurality of second portions of the wide-area electrode 140X. A second portion is a portion of the wide-area electrode 140X located between two first electrodes 120 arranged in the first direction G1 in plan view. As shown in Fig. 8D, the plurality of second portions are arranged along the second direction G2. As shown in Fig. 8D, the plurality of second portions includes one second portion adjacent to the first portion adjacent to the second display area 102 in the second direction G2. Specifically, the plurality of second portions is ten second portions. The thickness T12 of one second portion is measured at a middle position on the second portion in the second direction G2. A standard deviation of the thicknesses T11 of the ten first portions and the thicknesses T12 of the ten second portions is the second standard deviation σ2. The average of the thicknesses T11 of the ten first portions and the thicknesses T12 of the ten second portions is also referred to as "second average thickness µ2".

Since the wide-area electrode 140X does not include an electrode overlap area 145, the second standard deviation σ2 can be made smaller. As a range of the second standard deviation σ2, the aforementioned "range of the first standard deviation σ1" can be adopted. As a range of the second average thickness µ2, the aforementioned "range of the first average thickness µ1" can be adopted.

Constituent elements of the organic device 200 are described.

The substrate 110 may be a plate member having insulation properties. The substrate 110 preferably has transparency that allows passage of light.

In a case where the substrate 110 has predetermined transparency, it is preferable that the transparency of the substrate 110 be such transparency that a display can be carried out by allowing passage of light from an organic layer 130. For example, it is preferable that the transmittance of the substrate 110 in a visible light range be 70% or higher, more preferably 80% or higher. The transmittance of the substrate 110 is measured in conformity with "Plastics -- Determination of the total luminous transmittance of transparent materials -- Part 1: Single beam instrument" provide for in JIS K7361-1.

The substrate 110 may or may not have flexibility. An appropriate substrate 110 can be selected depending on the intended use of the organic device 200.

The substrate 110 can be made of a material such as either a rigid material such as quartz glass, Pyrex (registered trademark) glass, a synthetic quartz plate, or alkali-free glass or a flexible material such as a resin film, an optical resin plate, or thin glass. Further, the base material may be a layered product including a resin film and a barrier layer(s) on one or both surfaces of the resin film.

An appropriate thickness of the substrate 110 can be selected depending on the material of which the substrate 110 is made, the intended use of the organic device 200, or other conditions, but may for example be 0.005 mm or greater. The thickness of the substrate 110 may be 5 mm or less.

The element 115 can achieve some sort of function through either the application of a voltage between the first electrode 120 and the second electrode 140 or the flow of an electric current between the first electrode 120 and the second electrode 140. For example, in a case where the element 115 is a pixel of an organic EL display device, the element 115 can emit light that constitutes a picture.

The first electrode 120 contains a material having electric conductivity. For example, the first electrode 120 contains a metal, a metal oxide having electric conductivity, an inorganic material having electric conductivity, or other materials. The first electrode 120 may contain a metal oxide having transparency and electric conductivity, such as indium tin oxide.

The first electrode 120 can be made of a material such as a metal such as Au, Cr, Mo, Ag, or Mg, an inorganic oxide such as indium tin oxide called "ITO", indium zinc oxide called "IZO", zinc oxide, or indium oxide, or a conducting polymer such as metal-doped polythiophene. These electrically-conducting materials may each be used alone, or two or more of them may be used in combination. When two or more of these materials are used, layers made separately of each of the materials may be stacked. Further, an alloy containing two or more of these materials may be used. For example, a magnesium alloy such as MgAg or other materials can be used.

The organic layer 130 contains an organic material. The passage of electricity through the organic layer 130 allows the organic layer 130 to fulfill some sort of function. The passage of electricity means the application of a voltage to the organic layer 130 or the flow of an electric current through the organic layer 130. Usable examples of the organic layer 130 include a luminescent layer that emits light with the passage of electricity. The organic layer 130 may contain an organic semiconductor material.

A laminated structure including a first electrode 120, a first organic layer 130A, and the second electrode 140 is also referred to as "first element 115A". A laminated structure including a first electrode 120, a second organic layer 130B, and the second electrode 140 is also referred to as "second element 115B". A laminated structure including a first electrode 120, a third organic layer 130C, and the second electrode 140 is also referred to as "third element 115C". In a case where the organic device 200 is an organic EL display device, the first element 115A, the second element 115B, and the third element 115C are each a subpixel.

The following description uses the term and sign "element 115" to describe an element configuration common to the first element 115A, the second element 115B, and the third element 115C.

The application of a voltage between a first electrode 120 and the second electrode 140 drives an organic layer 130 located between the first electrode 120 and the second electrode 140. In a case where the organic layer 130 is a luminescent layer, light is emitted from the organic layer 130, and the light is extracted outward from the second electrode 140 or the first electrode 120.

In a case where the organic layer 130 includes a luminescent layer that emits light with the passage of electricity, the organic layer 130 may further include a hole injection layer, a hole transport layer, an electron transport layer, an electron injection layer, or other layers.

For example, in a case where the first electrode 120 is an anode, the organic layer 130 may have a hole injection and transport layer between the luminescent layer and the first electrode 120. The hole injection and transport layer may be a hole injection layer having a hole injection function, be a hole transport layer having a hole transport function, or have both a hole injection function and a hole transport function. Further, the hole injection and transport layer may be a stacked combination of a hole injection layer and a hole transport layer.

In a case where the second electrode 140 is a cathode, the organic layer 130 may have an electron injection and transport layer between the luminescent layer and the second electrode 140. The electron injection and transport layer may be an electron injection layer having an electron injection function, be an electron transport layer having an electron transport function, or have both an electron injection function and an electron transport function. Further, the electron injection and transport layer may be a stacked combination of an electron injection layer and an electron transport layer.

The luminescent layer contains a luminescent material. The luminescent layer may contain an additive that improves leveling properties.

As the luminescent material, a publicly-known material can be used. Usable examples of such luminescent materials include a pigment material, a metal complex material, and a polymeric material.

Usable examples of such pigment materials include a cyclopentadiene derivative, a tetraphenyl butadiene derivative, a triphenylamine derivative, an oxadiazole derivative, a pyrazoloquinoline derivative, a distyryl benzene derivative, a distyryl arylene derivative, a silole derivative, a thiophene ring derivative, a pyridine ring compound, a perinone derivative, a perylene derivative, an oligothiophene derivative, an oxadiazole dimer, and a pyrazoline dimer.

Usable examples of such metal complex materials include an aluminum quinolinol complex, a benzoquinolinol beryllium complex, a benzoxazole zinc complex, a benzothiazole zinc complex, an azomethyl zinc complex, a porphyrin zinc complex, and a europium complex. Each of these metal complexes has Al, Zn, Be, or a rare earth metal such as Tb, Eu, or Dy as a central metal and an oxadiazole, thiadiazole, phenylpyridine, phenylbenzoimidazole, or quinoline structure as a ligand.

Usable examples of such polymeric materials include a polyparaphenylenevinylene derivative, a polythiophene derivative, a polyparaphenylene derivative, a polysilane derivative, a polyacetylene derivative, a polyvinylcarbazole derivative, a polyfluorene derivative, a polyquinoxaline derivative, and a copolymer thereof.

The luminescent layer may contain a dopant for the purpose of, for example, improving luminous efficiency and changing luminous wavelength. Usable examples of such dopants include a perylene derivative, a coumalin derivative, a rubrene derivative, a quinacridone derivative, a squarylium derivative, a porphyrin derivative, a styryl pigment, a tetracene derivative, a pyrazoline derivative, decacyclene, phenoxazone, a quinoxaline derivative, a carbazole derivative, and a fluorene derivative. Alternatively, as the dopant, a phosphoresce organic metal complex having an ion of a heavy metal such as platinum or iridium at the center can be used. One type of dopant may be used alone, or two or more types of dopant may be used.

Further, usable examples of luminescent materials and dopants include materials described in paragraphs [0094] to [0099] of Japanese Unexamined Patent Application Publication No. 2010-272891 and paragraphs [0053] to [0057] of International Publication No. 2012/132126.

The film thickness of the luminescent layer is not limited to particular film thicknesses, provided it can provide a platform for recombination of an electron and a hole and express a luminescent function. For example, the film thickness of the luminescent layer can for example be 1 nm or greater and 500 nm or less.

The hole injection and transport layer can be made of a publicly-known hole injection and transport material. Usable examples of such hole injection and transport materials include a triazole derivative, an oxadiazole derivative, an imidazole derivative, a polyarylalkane derivative, a pyrazoline derivative, a pyrazolone derivative, a phenylenediamine derivative, an arylamine derivative, an amino-substituted chalcone derivative, an oxazole derivative, a styryl anthracene derivative, a fluorenone derivative, a hydrazone derivative, a stilbene derivative, a sirazane derivative, a polythiophene derivative, a polyaniline derivative, a polypyrrole derivative, a phenylamine derivative, an anthracene derivative, a carbazole derivative, a fluorene derivative, a distyryl benzene derivative, a polyphenylenevinylene derivative, a porphyrin derivative, and a styrylamine derivative. Further examples include a spiro compound, a phthalocyanine compound, and a metal oxide. Further, for example, the compounds described in Japanese Unexamined Patent Application Publication No. 2011-119681, International Publication No. 2012/018082, Japanese Unexamined Patent Application Publication No. 2012-069963, paragraph [0106] of International Publication No. 2012/132126 can be selected as appropriate for use.

It should be noted that in a case where the hole injection and transport layer is a stacked combination of a hole injection layer and a hole transport layer, either the hole injection layer or the hole transport layer may contain an additive A or both the hole injection layer and the hole transport layer may contain the additive A. The additive A may be a low-molecular compound or a high-molecular compound. Specifically, a fluorine compound, an ester compound, a hydrocarbon compound, or other compounds can be used.

The electron injection and transport layer can be made of a publicly-known electron injection and transport material. Usable examples of such electron injection and transport materials include an alkali metal, an alkali metal alloy, an alkali metal halide, an alkaline earth metal, an alkaline earth metal halide, an alkaline earth metal oxide, an alkali metal organic complex, a magnesium halide or oxide, and aluminum oxide. Further usable examples of such electron injection and transport materials include bathocuproine, bathophenanthroline, a phenanthroline derivative, a triazole derivative, an oxadiazole derivative, a pyridine derivative, a nitro-substituted fluorene derivative, an anthraquinodimethane derivative, a diphenylquinone derivative, a thiopyrandioxide derivative, an aromatic ring tetracarboxylic acid anhydride such as naphthalene or perylene, carbodiimide, a fluorenylidene methane derivative, a metal complex such as a quinolinol complex, an anthraquinodimethane derivative, an anthrone derivative, a quinoxaline derivative, a phthalocyanine compound, and a distyrylpyrazine derivative.

Alternatively, the electron injection and transport layer may be a metal-doped layer formed by doping an electron transport organic material with an alkali metal or an alkali earth metal. Usable examples of such electron transport organic materials include bathocuproine, bathophenanthroline, a phenanthroline derivative, a triazole derivative, an oxadiazole derivative, a pyridine derivative, a metal complex such as tris(8-quinolinolato)aluminum (Alq₃), and polymeric derivatives thereof. Further, usable examples of the metal with which the electron transport organic material is doped include Li, Cs, Ba, and Sr.

The second electrode 140 contains a material having electric conductivity, such as a metal. The second electrode 140 is formed on top of the organic layer 130 by a vapor deposition method that involves the use of the after-mentioned mask. The second electrode 140 can be made of a material such as platinum, gold, silver, copper, iron, tin, chromium, indium, lithium, sodium, potassium, calcium, magnesium, or carbon. These materials may each be used alone, or two or more of them may be used in combination. When two or more of these materials are used, layers made separately of each of the materials may be stacked. Further, an alloy containing two or more of these materials may be used. For example, a magnesium alloy such as MgAg, an aluminum alloy such as AILi, AICa, or AIMg, an alkali metal or alkali earth metal alloy, or other materials can be used.

The thickness of the second electrode 140 may for example be 5 nm or greater, 10 nm or greater, 50 nm or greater, or 100 nm or greater. The thickness of the second electrode 140 may for example be 200 nm or less, 500 nm or less, 1 µm or less, or 100 µm or less. The thickness of the second electrode 140 may fall within a range defined by a first group consisting of 5 nm, 10 nm, 50 nm, and 100 nm and/or a second group consisting of 200 nm, 500 nm, 1 µm, and 100 µm. The thickness of the second electrode 140 may fall within a range defined by a combination of any one of the values included in the aforementioned first group and any one of the values included in the aforementioned second group. The thickness of the second electrode 140 may fall within a range defined by a combination of any two of the values included in the aforementioned first group. The thickness of the second electrode 140 may fall within a range defined by a combination of any two of the values included in the aforementioned second group. The thickness of the second electrode 140 may for example be 5 nm or greater and 100 µm or less, 5 nm or greater and 1 µm or less, 5 nm or greater and 500 nm or less, 5 nm or greater and 200 nm or less, 5 nm or greater and 100 nm or less, 5 nm or greater and 50 nm or less, 5 nm or greater and 10 nm or less, 10 nm or greater and 100 µm or less, 10 nm or greater and 1 µm or less, 10 nm or greater and 500 nm or less, 10 nm or greater and 200 nm or less, 10 nm or greater and 100 nm or less, 10 nm or greater and 50 nm or less, 50 nm or greater and 100 µm or less, 50 nm or greater and 1 µm or less, 50 nm or greater and 500 nm or less, 50 nm or greater and 200 nm or less, 50 nm or greater and 100 nm or less, 100 nm or greater and 100 µm or less, 100 nm or greater and 1 µm or less, 100 nm or greater and 500 nm or less, 100 nm or greater and 200 nm or less, 200 nm or greater and 100 µm or less, 200 nm or greater and 1 µm or less, 200 nm or greater and 500 nm or less, 500 nm or greater and 100 µm or less, 500 nm or greater and 1 µm or less, or 1 µm or greater and 100 µm or less.

The smaller the thickness of the second electrode 140 is, the higher the transmittance of the second electrode 140 becomes and the higher the transmittance of the non-transmissive area becomes. Light falling on the non-transmissive area can reach the sensor according to the transmittance of the non-transmissive area. Increasing the transmittance of the non-transmissive area makes it possible to increase the amount of light that the sensor receives.

The thickness of each constituent element of the organic device 200, such as the thickness of the substrate 110 and the thickness of the second electrode 140, is measured by observing an image of a cross-section of the organic device 200 with a scanning electron microscope. The dimensions K2 and K3 of the electrode overlap area 145 too are measured by observing an image of a cross-section of the organic device 200 with a scanning electron microscope.

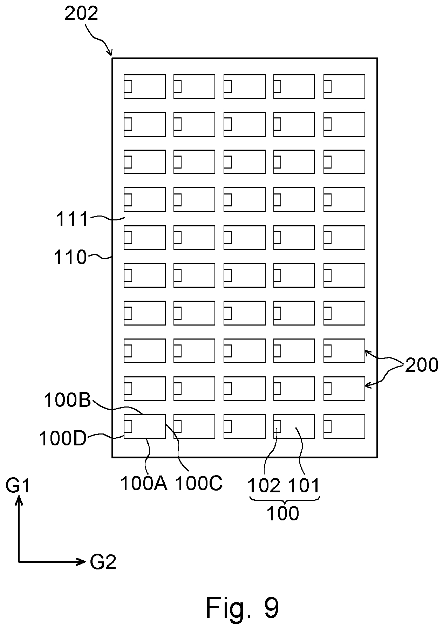

In a manufacturing method for an organic device 200, an organic device group 202 such as that shown in Fig. 9 may be fabricated. The organic device group 202 includes two or more organic devices 200. For example, the organic device group 202 may include organic devices 200 arranged in the first direction G1 and the second direction G2. The two or more organic devices 200 may include one common substrate 110. For example, the organic device group 202 may include layers, such as first electrodes 120, organic layers 130, and second electrodes 140, located on top of one substrate 110, that constitute the two or more organic devices 200. Dividing the organic device group 202 gives organic devices 200.

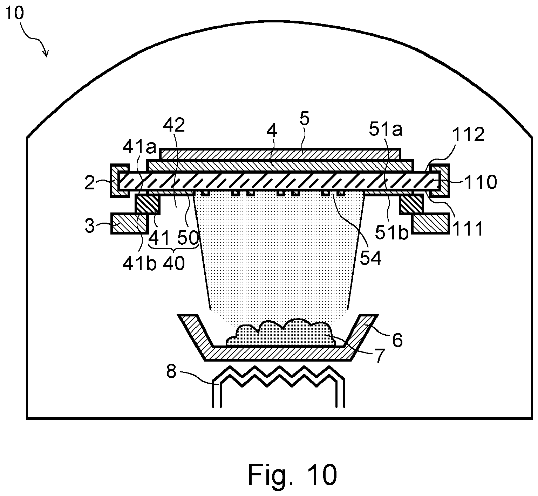

Next, a method for forming the second electrode 140 of the aforementioned organic device 200 by a vapor deposition method is described. Fig. 10 is a diagram showing an example of a vapor deposition apparatus 10. The vapor deposition apparatus 10 executes a vapor deposition process of depositing a vapor-deposited material on a physical object.

The vapor deposition apparatus 10 may include a vapor source 6, a heater 8, and a mask device 40 inside thereof. The vapor deposition apparatus 10 may include exhaust means for bringing the interior of the vapor deposition apparatus 10 into a vacuum atmosphere. The vapor source 6 is for example a crucible. The vapor 6 accommodates a vapor-deposited material 7 such as an electrically-conducting material. The heater 8 heats the vapor source 6 so that the vapor-deposited material 7 evaporates in a vacuum atmosphere. The mask device 40 is placed opposite the crucible 6.

As shown in Fig. 10, the mask device 40 may include at least one mask 50 and a frame 41 supporting the mask 50. The frame 41 may include a first frame surface 41a and a second frame surface 41b. The mask 50 may be fixed to the first frame surface 41a. The second frame surface 41b is located opposite the first frame surface 41a. Further, the frame 41 may include an opening 42. The opening 42 is bored from the first frame surface 41a to the second frame surface 41b. The mask 50 may be fixed to the frame 41 so as to pass transversely across the opening 42 in plan view. Further, the frame 41 may support the mask 50 while stretching the mask 50 in a direction parallel with the plane of the mask 50. This makes it possible to restrain the mask 50 from warping.

As the mask 50, the after-mentioned first and second masks 50A and 50B may be used. The following description uses the term and sign "mask 50" to describe a mask configuration common to the first mask 50A and the second mask 50B. Similarly, as for the after-mentioned constituent elements of the mask, such as a through hole and a shielding area, exclusivelynumerical signs having no alphabetical letters added thereto, such as "54" and "55", are used as signs to describe contents common to the first mask 50A and the second mask 50B. Meanwhile, signs made by adding corresponding alphabetical letters such as "A" and "B" to the ends of numbers may be used to describe contents peculiar to the first mask 50A and the second mask 50B, respectively.

The mask 50 of the mask device 40 faces the substrate 110. The substrate 110 is a physical object to which the vapor-deposited material 7 is caused to adhere. The substrate 110 includes a first surface 111 and a second surface 112. The first surface 111 faces the mask 50. The mask 50 includes a plurality of through holes 54. The through holes 54 allow passage of the vapor-deposited material 7 having flown from the vapor source 6. The vapor-deposited material 7 having passed through the through holes 54 adheres to the first surface 111 of the substrate 110. The mask 50 includes a first surface 51a and a second surface 51b. The first surface 51a faces the first surface 111. The second surface 51b is located opposite the first surface 51a. The through holes 54 are bored from the first surface 51a to the second surface 51b.

The vapor deposition apparatus 10 may include a substrate holder 2 that holds the substrate 110. The substrate holder 2 may be movable in a direction parallel with the thickness of the substrate 110. The substrate holder 2 may be movable in a direction parallel with the plane of the substrate 110. The substrate holder 2 may control the tilt of the substrate 110. For example, the substrate holder 2 may include a plurality of chucks attached to outer edges of the substrate 110. Each chuck may be independently movable in the directions parallel with the thickness and plane of the substrate 110.

The vapor deposition apparatus 10 may include a mask holder 3 that holds the mask device 40. The mask holder 3 may be movable in a direction parallel with the thickness of the mask 50. The mask holder 3 may be movable in a direction parallel with the plane of the mask 50. For example, the mask holder 3 may include a plurality of chucks attached to outer edges of the frame 41. Each chuck may be independently movable in the directions parallel with the thickness and plane of the mask 50.

Moving at least either the substrate holder 2 or the mask holder 3 makes it possible to adjust the position of the mask 50 of the mask device 40 with respect to the substrate 110.

The vapor deposition apparatus 10 may include a cooling plate 4. The cooling plate 4 may be disposed to face the second surface 112 of the substrate 110. The cooling plate 4 may have inside thereof a flow passage through which to circulate refrigerant. The cooling plate 4 can suppress a rise in temperature of the substrate 110 during a vapor deposition step.

The vapor deposition apparatus 10 may include a magnet 5 disposed to face the second surface 112. The magnet 5 may be placed on top of the cooling plate 4. The magnet 5 magnetically attracts the mask 50 toward the substrate 110. This makes it possible to reduce or eliminate a gap between the mask 50 and the substrate 110. This makes it possible to reduce the occurrence of a shadow in the vapor deposition step. This makes it possible to increase the dimensional accuracy and positional accuracy of the second electrode 140. The term "shadow" as used herein means a phenomenon in which the vapor-deposited material 7 enters the gap between the mask 50 and the substrate 110 and thereby makes the thickness of the second electrode 140 uneven.

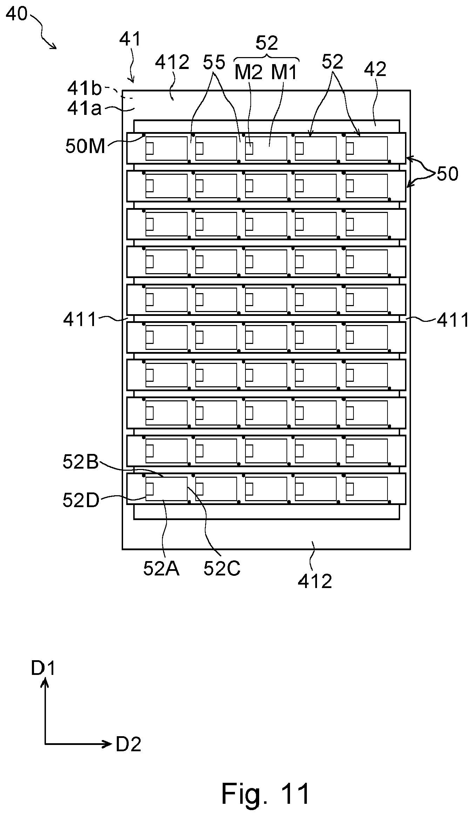

Next, the mask device 40 is described. Fig. 11 is a plan view showing the mask device 40. The mask device 40 may include two or more masks 50. The masks 50 may be fixed to the frame 41, for example, by welding.

The frame 41 includes a pair of first sides 411 and a pair of second sides 412. The frame 41 may have rectangular contours. The masks 50 may be fixed to the first sides 411 with tension applied to the masks 50. The first sides 411 may be longer than the second sides 412. The frame 41 may include an opening 42 surrounded by the pair of first sides 411 and the pair of second sides 412.

The masks 50 have a mask first direction D1 and a mask second direction D2 intersecting the mask first direction D1. The mask first direction D1 may be orthogonal to the mask second direction D2. The mask first direction D1 may correspond to the aforementioned first direction G1, and the mask second direction D2 may correspond to the aforementioned second direction G2. The masks 50 may extend in the mask second direction D2. Ends of the masks 50 in the mask second direction D2 may be fixed to the first sides 411.

Each of the masks 50 includes at least one cell 52. The cell 52 includes a through hole 54 and a shielding area 55. Each of the masks 50 may include two or more cells 52. The two or more cells 52 may be arranged in the mask second direction D2. In a case where the masks 50 are used to fabricate a display device such as an organic EL display device, one cell 52 may correspond to one display area, i.e. one screen, of the organic EL display device. One cell 52 may correspond to a plurality of display areas. Each of the masks 50 may include a shielding area 55 located between cells 52. Although not illustrated, each of the masks 50 may include a through hole 54 located between cells 52.

Each of the cells 52 may have, for example, substantially quadrangular contours in plan view, more accurately substantially rectangular contours in plan view. The contours of each of the cells 52 may include a cell first side 52A, a cell second side 52B, a cell third side 52C, and a cell fourth side 52D. The cell first side 52A and the cell second side 52B may be opposite to each other in the mask first direction D1. The cell third side 52C and the cell fourth side 52D may be opposite to each other in the mask second direction D2.

When seen along a direction normal to the first surface 51a, each of the masks 50 includes a mask first area M1 and a mask second area M2. The mask first area M1 corresponds to the first display area 101 of an organic device 200. The mask second area M2 corresponds to the second display area 102 of the organic device 200. The mask second area M2 may be in contact with the cell fourth side 52D.

The masks 50 may have alignment marks 50M. Each of the alignment marks 50M is formed, for example, at a corner of a cell 52 of the masks 50. In a step of forming the second electrode 140 on the substrate 110 by a vapor deposition method using the masks 50, the alignment marks 50M may be utilized for alignment of the masks 50 to the substrate 110. Although not illustrated, the alignment marks 50M may be formed in such positions as to overlap the frame 41. In fabricating the mask device 40, the alignment marks 50M may be used for alignment of the masks 50 and the frame 41.

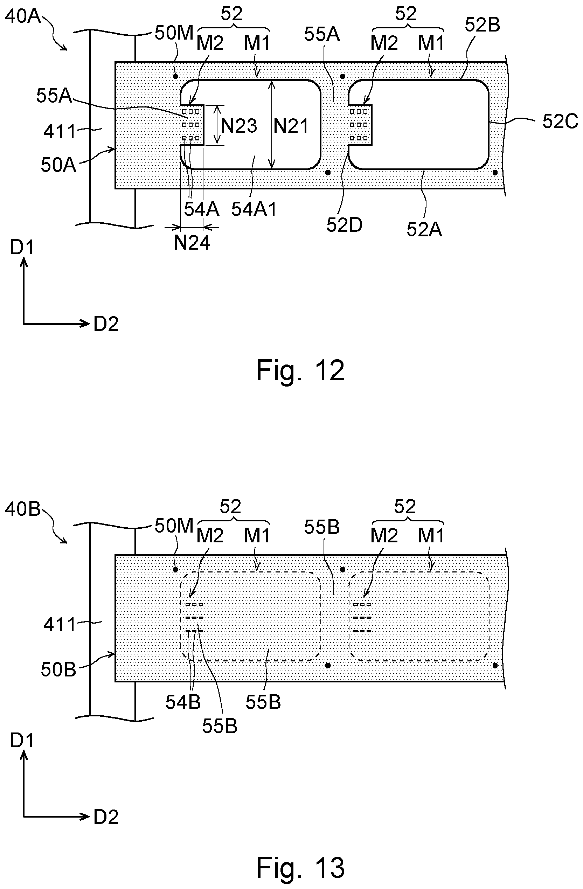

In a step of forming the second electrode 140, a plurality of the masks 50 may be used. For example, as shown in Figs. 12 and 13, the masks 50 may include a first mask 50A and a second mask 50B. The first mask 50A and the second mask 50B may constitute different mask devices 40. A mask device 40 including the first mask 50A is also referred to as "first mask device 40A". A mask device 40 including the second mask 50B is also referred to as "second mask device 40B".

In the step of forming the second electrode 140, for example, the first layer 140A of the second electrode 140 is formed on the substrate 110 by using the first mask device 40A in the vapor deposition apparatus 10. Then, the second layer 140B of the second electrode 140 is formed on the substrate 110 by using the second mask device 40B in the vapor deposition apparatus 10. Thus, in the step of forming the second electrode 140 of an organic device 200, the plurality of masks 50 such as the first mask 50A and the second mask 50B are used in sequence. A group of masks 50 that is used to form the second electrode 140 of an organic device 200 is also referred to "group of masks".

As shown in Fig. 12, the first mask 50A includes a first through hole 54A. In the mask first area M1, the first through hole 54A may spread in a gapless manner. The first through hole 54A located in the mask first area M1 is also referred to as "wide-area through hole", and is denoted by the sign "54A1". The wide-area through hole 54A1 may spread along the cell first side 52A, the cell second side 52B, and the cell third side 52C. For example, the wide-area through hole 54A1 may be in contact with the whole area of the cell first side 52A, the whole area of the cell second side 52B, and the whole area of the cell third side 52C. The wide-area through hole 54A1 may be in partial contact with the cell fourth side 52D.

As shown in Fig. 12, the mask second area M2 of the first mask 50A may include two or more first through holes 54A and a first shielding area 55A. The first through holes 54A of the mask second area M2 may be surrounded by the first shielding area 55A in plan view. The first shielding area 55A of the mask second area M2 may be connected to a first shielding area 55A around the cell 52.

As shown in Fig. 12, the first shielding area 55A of the mask second area M2 has a dimension N23 in the mask first direction D1, and has a dimension N24 in the mask second direction D2. As a range of the dimension N23, the aforementioned "range of the dimension N13" can be adopted.

The dimension N24 may be substantially equal to the dimension N23. The dimension N24 may be equal to or smaller than the dimension N23. As a range of N24/N23, which is the ratio of the dimension N24 to the dimension N23, the aforementioned "range of N14/N13" can be adopted.

As shown in Fig. 12, the cell 52 has a dimension N21 in the mask first direction D1. As a range of N23/N21, which is the ratio of the dimension N23 to the dimension N21, the aforementioned "range of N13/N11" can be adopted.

As shown in Fig. 13, the second mask 50B includes a second through hole 54B. The mask second area M2 of the second mask 50B may include two or more second through holes 54B and a second shielding area 55B. The second through holes 54B may be surrounded by the second shielding area 55B in plan view. The second shielding area 55B of the mask second area M2 may be connected to a second shielding area 55B around the cell 52.

As shown in Fig. 13, the mask first area M1 of the second mask 50B include a second shielding area 55B. The second shielding area 55B of the mask first area M1 may spread along the cell first side 52A, the cell second side 52B, and the cell third side 52C. The mask first area M1 of the second mask 50B may not include a second through hole 54B. In this case, the wide-area electrode 140X does not include an electrode overlap area 145.

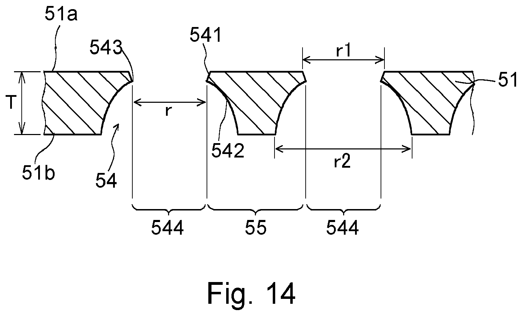

Fig. 14 is a diagram showing an example of a cross-sectional structure of a mask 50. The mask 50 has a metal plate 51 and a plurality of through holes 54 formed in the metal plate 51. The through holes 54 are bored through the metal plate 51 from the first surface 51a to the second surface 51b.

Each of the through holes 54 may include a first concave portion 541 and a second concave portion 542. The first concave portion 541 is located in the first surface 51a. The second concave portion 542 is located in the second surface 51b. The first concave portion 541 is connected to the second concave portion 542 in a direction parallel with the thickness of the metal plate 51.

In a plan view, a dimension r2 of the second concave portion 542 may be larger than a dimension r1 of the first concave portion 541. The first concave portion 541 may be formed by processing the metal plate 51, for example, by etching from the first surface 51a. The second concave portion 542 may be formed by processing the metal plate 51, for example, by etching from the second surface 51b. The first concave portion 541 and the second concave portion 542 are connected to each other by a connecting portion 543.

The sign "544" denotes a through portion. An opening area of each of the through holes 54 in plan view reaches its minimum in the through portion 544. The through portion 544 may be defined by the connecting portion 543.

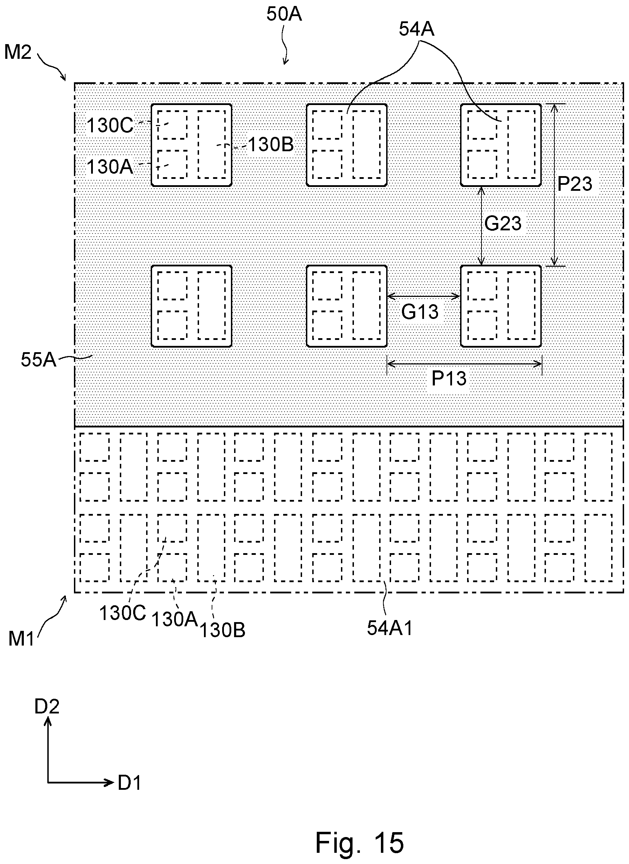

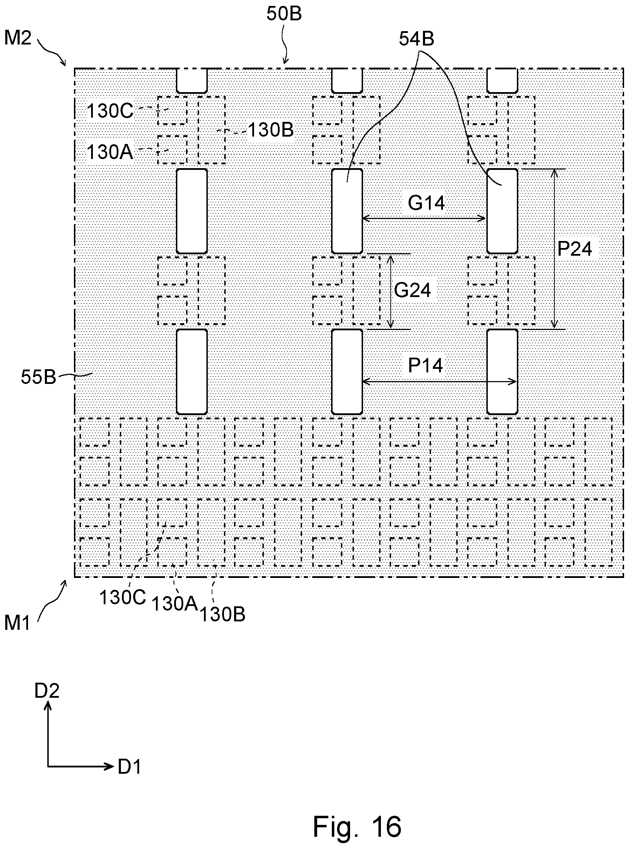

In a vapor deposition method that involves the use of the mask 50, the adhesion to the substrate 110 of a vapor-deposited material 7 having passed through the through portions 544 of the through holes 54 from the second surface 51b to the first surface 51a causes layers such as the aforementioned first and second layers 140A and 140B to be formed on the substrate 110. The contours in an in-plane direction of the substrate 110 of a layer that is formed on the substrate 110 are defined by the contours of the through portions 544 in plan view. The contours of a through hole 54 shown in a plan view such as Figs. 15 and 16, which will be described later, are the contours of a through portion 544. The area of a through hole 54 may be the area of a through portion 544. A dimension of a through hole 54 in plan view may be a dimension r of a through potion 544.

An area of the metal plate 51 other than the through portions 544 can shield a vapor-deposited material 7 moving toward the substrate 110. The area of the metal plate 51 other than the through portions 544 constitutes a shielding area 55. In a plan view of a mask 50, such as Figs. 12, 13, 15, or 16, the shielding area 55 is hatched.

The shielding area 55 of the mask second area M2 may include a concave portion that does not pass through the metal plate 51. Providing a concave portion in the mask second area M2 makes it possible to reduce the rigidity of the mask second area M2. This makes it possible to reduce the difference between the rigidity of the mask second area M2 and the rigidity of the first mask area M1. This makes it possible to restrain a wrinkle from occurring in the mask 50 due to the difference in rigidity. A wrinkle tends to occur, for example, when tension is applied to the mask 50.

The thickness T of the mask 50 may for example be 5 µm or greater, 10 µm or greater, 15 µm or greater, or 20 µm or greater. The thickness T of the mask 50 may for example be 25 µm or less, 30 µm or less, 50 µm or less, or 100 µm or less. The thickness T of the mask 50 may fall within a range defined by a first group consisting of 5 µm, 10 µm, 15 µm, or 20 µm and/or a second group consisting of 25 µm, 30 µm, 50 µm, and 100 µm. The thickness T of the mask 50 may fall within a range defined by a combination of any one of the values included in the aforementioned first group and any one of the values included in the aforementioned second group. The thickness T of the mask 50 may fall within a range defined by a combination of any two of the values included in the aforementioned first group. The thickness T of the mask 50 may fall within a range defined by a combination of any two of the values included in the aforementioned second group. The thickness T of the mask 50 may for example be 5 µm or greater and 100 µm or less, 5 µm or greater and 50 µm or less, 5 µm or greater and 30 µm or less, 5 µm or greater and 25 µm or less, 5 µm or greater and 20 µm or less, 5 µm or greater and 15 µm or less, 5 µm or greater and 10 µm or less, 10 µm or greater and 100 µm or less, 10 µm or greater and 50 µm or less, 10 µm or greater and 30 µm or less, 10 µm or greater and 25 µm or less, 10 µm or greater and 20 µm or less, 10 µm or greater and 15 µm or less, 15 µm or greater and 100 µm or less, 15 µm or greater and 50 µm or less, 15 µm or greater and 30 µm or less, 15 µm or greater and 25 µm or less, 15 µm or greater and 20 µm or less, 20 µm or greater and 100 µm or less, 20 µm or greater and 50 µm or less, 20 µm or greater and 30 µm or less, 20 µm or greater and 25 µm or less, 25 µm or greater and 100 µm or less, 25 µm or greater and 50 µm or less, 25 µm or greater and 30 µm or less, 30 µm or greater and 100 µm or less, 30 µm or greater and 50 µm or less, or 50 µm or greater and 100 µm or less.

As a method for measuring the thickness T of the mask 50, a contact measurement method is employed. The contact measurement method involves the use of a HEIDENHAIN's length gauge HEIDENHAIN-METRO "MT1271", which includes a plunger of a ball bush guide type.

The cross-sectional shapes of the through holes 54 are not limited to the shapes shown in Fig. 14. Further, as a method for forming the through holes 54, various methods, as well as etching, can be employed. For example, the mask 50 may be formed by applying plating so that the through holes 54 are formed.

The mask 50 can be made of material such as an iron alloy containing nickel. The iron alloy may further contain cobalt in addition to nickel. For example, the mask 50 can be made of an iron alloy whose total nickel and cobalt content is 30 mass% or higher and 54 mass% or lower and whose cobalt content is 0 mass% or higher and 6 mass% or lower. Usable examples of iron alloys containing nickel or nickel and cobalt include an Invar alloy containing 34 mass% or higher and 38 mass% or lower of nickel, a Super-Invar alloy further containing cobalt in addition to 30 mass% or higher and 34 mass% or lower of nickel, and a low-thermal expansion Fe-Ni plated alloy containing 38 mass% or higher and 54 mass% or lower of nickel. Using such an iron alloy makes it possible to lower the coefficient of thermal expansion of the mask 50. For example, in a case where the substrate 110 is a glass substrate, the coefficient of thermal expansion of the mask 50 can be made as low as that of the glass substrate. This makes it possible to, during the vapor deposition step, restrain the dimensional accuracy and positional accuracy of a vapor-deposited layer that is formed on the substrate 110 from deteriorating due to the difference in coefficient of thermal expansion between the mask 50 and the substrate 110.

Next, the first mask 50A is described in detail. Fig. 15 is an enlarged plan view of the mask first and second areas M1 and M2 of the first mask 50A. Fig. 15 uses dotted lines to indicate organic layers 130 that overlap the first mask 50A during the vapor deposition step. The first through holes 54A may overlap the organic layers 130. As shown in Fig. 15, each of the first through holes 54A located in the mask second area M2 may overlap two or more sub-organic layers. Although not illustrated, each of the first through holes 54A may overlap one sub-organic layer.

In the mask second area M2, the first through holes 54A may be arranged at a thirteenth pitch P13 along the mask first direction D1. The thirteenth pitch P13 may be greater than the aforementioned eleventh pitch P11 between organic layers 130. The thirteenth pitch P13 may be equal to the aforementioned twelfth pitch P12 between organic layers 130. As a range of P13/P11, which is the ratio of the thirteenth pitch P13 to the eleventh pitch P11, the aforementioned "range of P12/P11" can be adopted.

In the mask second area M2, the first through holes 54A may be arranged at a twenty-third pitch P23 along the mask second direction D2. The twenty-third pitch P23 may be greater than the aforementioned twenty-first pitch P21 between organic layers 130. The twenty-third pitch P23 may be equal to the aforementioned twenty-second pitch P22 between organic layers 130. As a range of P23/P21, which is the ratio of the twenty-third pitch P23 to the twenty-first pitch P21, the aforementioned "range of P12/P11" can be adopted.

The sign "G13" denotes a gap between two first through holes 54A, located in the mask second area M2, that are adjacent to each other in the mask first direction D1.

G13/P13, which is the ratio of the gap G13 to the thirteenth pitch P13, may for example be 0.1 or higher, 0.2 or higher, or 0.4 or higher. G13/P13 may for example be 0.6 or lower, 0.8 or lower, or 0.9 or lower. G13/P13 may fall within a range defined by a first group consisting of 0.1, 0.2, and 0.4 and/or a second group consisting of 0.6, 0.8, and 0.9. G13/P13 may fall within a range defined by a combination of any one of the values included in the aforementioned first group and any one of the values included in the aforementioned second group. G13/P13 may fall within a range defined by a combination of any two of the values included in the aforementioned first group. G13/P13 may fall within a range defined by a combination of any two of the values included in the aforementioned second group. G13/P13 may for example be 0.1 or higher and 0.9 or lower, 0.1 or higher and 0.8 or lower, 0.1 or higher and 0.6 or lower, 0.1 or higher and 0.4 or lower, 0.1 or higher and 0.2 or lower, 0.2 or higher and 0.9 or lower, 0.2 or higher and 0.8 or lower, 0.2 or higher and 0.6 or lower, 0.2 or higher and 0.4 or lower, 0.4 or higher and 0.9 or lower, 0.4 or higher and 0.8 or lower, 0.4 or higher and 0.6 or lower, 0.6 or higher and 0.9 or lower, 0.6 or higher and 0.8 or lower, 0.8 or higher and 0.9 or lower.

The sign "G23" denotes a gap between two first through holes 54A, located in the mask second area M2, that are adjacent to each other in the mask second direction D2. As a range of G23/P23, which is the ratio of the gap G23 to the twenty-third pitch P23, the aforementioned "range of G13/P13" can be adopted.

Next, the second mask 50B is described in detail. Fig. 16 is an enlarged plan view of the mask first and second areas M1 and M2 of the second mask 50B. A repeated description of portions of the second mask 50B that are configured in a manner similar to those of the first mask 50A may be omitted.

In the mask second area M2, the second through holes 54B may be arranged at a fourteenth pitch P14 along the mask first direction D1. The fourteenth pitch P14 may be greater than the aforementioned eleventh pitch P11 between organic layers 130. The fourteenth pitch P14 may be equal to the aforementioned twelfth pitch P12 between organic layers 130. As a range of P14/P11, which is the ratio of the fourteenth pitch P14 to the eleventh pitch P11, the aforementioned "range of P12/P11" can be adopted.

In the mask second area M2, the second through holes 54B may be arranged at a twenty-fourth pitch P24 along the mask second direction D2. The twenty-fourth pitch P24 may be greater than the aforementioned twenty-first pitch P21 between organic layers 130. The twenty-fourth pitch P24 may be equal to the aforementioned twenty-second pitch P22 between organic layers 130. As a range of P24/P21, which is the ratio of the twenty-fourth pitch P24 to the twenty-first pitch P21, the aforementioned "range of P12/P11" can be adopted.

The sign "G14" denotes a gap between two second through holes 54B, located in the mask second area M2, that are adjacent to each other in the mask first direction D1. As a range of G14/P14, which is the ratio of the gap G14 to the fourteenth pitch P14, the aforementioned "range of G13/P13" can be adopted.

The sign "G24" denotes a gap between two second through holes 54B, located in the mask second area M2, that are adjacent to each other in the mask second direction D2. As a range of G24/P24, which is the ratio of the gap G24 to the twenty-fourth pitch P24, the aforementioned "range of G13/P13" can be adopted.

In a method for measuring the shapes and arrangement of the through holes 54A and 54B of the masks 50A and 50B, parallel light falls on one of the first and second surfaces 51a and 51b along a direction normal to each mask. The parallel light is emitted through the other of the first and second surfaces 51a and 51b. The shape of an area occupied by the light thus emitted is measured as the shape of a through hole 54.

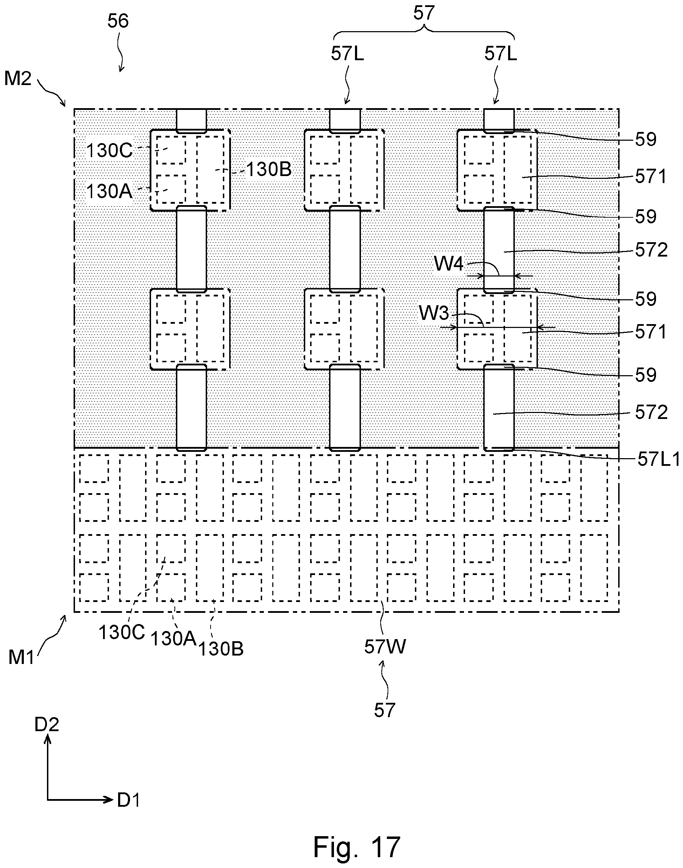

Next, a positional relationship between the first mask 50A and the second mask 50B is described. Fig. 17 is a plan view showing a mask stack 56. The mask stack 56 includes a stack of two or more masks 50. The mask stack 56 shown in Fig. 17 includes a stack of first and second masks 50A and 50B.

In the mask stack 56, the respective alignment marks 50M of the masks 50A to 50B may overlap each other. Alternatively, the masks 50A to 50B may be stacked on the basis of the arrangement of the respective cells 52 of the masks 50A and 50B. Alternatively, the masks 50A to 50B may be stacked on the basis of the arrangement of the respective through holes 54A to 54B and shielding areas 55A to 55B of the masks 50A and 50B. In stacking the masks 50A to 50B, tension may or may not be applied to the masks 50A to 50B.

A diagram of a stack of two or more masks 50 may be obtained by superimposing image data representing the respective masks 50. For example, first, a photography apparatus is used to acquire image data regarding the contours of the respective through holes 54A to 54B of the masks 50A to 50B. Then, an image processor is used to superimpose image data representing the respective masks 50A to 50B. As a result, a diagram such as Fig. 17 can be created. In acquiring the image data, tension may or may not be applied to the masks 50A to 50B. Alternatively, a diagram of a stack of two or more masks 50 may be obtained by superimposing design drawings for manufacturing the respective masks 50A to 50B.

As shown in Fig. 17, the mask stack 56 includes a through area 57. The through area 57 includes at least one of the respective through holes 54A to 54B of the masks 50A to 50B in plan view. That is, the through area 57 overlaps at least any of the respective through holes 54A to 54B of the masks 50A to 50B in plan view. Accordingly, in the vapor deposition step, at least one layer of second electrode 140 is formed in an area of the substrate 110 corresponding to the through area 57.

In a plan view, the mask stack 56 includes cells 52 each of which includes a mask first area M1 and a mask second area M2. As shown in Fig. 17, in the mask first area M1, the through area 57 may spread in a gapless manner. The through area 57 located in the mask first area M1 is also referred to as "wide-area through area", and is denoted by the sign "57W". The wide-area through area 57W includes a wide-area through hole 54A1 of the first mask 50A. As with the wide-area through hole 54A1, the wide-area through area 57W may spread along the cell first side 52A, the cell second side 52B, and the cell third side 52C. For example, the wide-area through area 57W may be in contact with the whole area of the cell first side 52A, the whole area of the cell second side 52B, and the whole area of the cell third side 52C. The wide-area through area 57W may be in partial contact with the cell fourth side 52D.

As shown in Fig. 17, in the mask second area M2, the through area 57 may include two or more through lines 57L. The through lines 57L may be arranged in the mask first direction D1. The through lines 57L may extend in the mask second direction D2. For example, each of the through lines 57L may include a third end 57L1 connected to the wide-area through area 57W in plan view. Each of the through lines 57L may include a fourth end located opposite the third end 57L1 in the mask second direction D2. The fourth end may not be connected to the wide-area through area 57W in plan view. The fourth end may be located at the cell fourth side 52D.

Each of the through lines 57L may include a first through section 571 and a second through section 572. The first through section 571 may overlap an organic layer 130 in plan view. The second through section 572 may be connected to the first through section 571. The first through section 571 may be constituted by a first through hole 54A of the first mask 50A. The second through section 572 may be constituted by a second through hole 54B of the second mask 50B. The first through section 571 and the second through section 572 may be alternately arranged in the mask second direction D2.

The first through section 571 has a third width W3. The second through section 572 has a fourth width W4. The third width W3 and the fourth width W4 are a dimension of the first through section 571 and a dimension of the second through section 572, respectively, in a direction orthogonal to a direction in which the first through section 571 and the second through section 572 are arranged. The fourth width W4 may be smaller than the third width W3. As a range of W4/W3, which is the ratio of the fourth width W4 to the third width W3, the aforementioned "range of W2/W1" can be adopted.

The occupancy of the through area 57 in the mask second area M2 may for example be 0.1 or higher, 0.2 or higher, or 0.4 or higher. The occupancy of the through area 57 in the mask second area M2 may for example be 0.6 or lower, 0.8 or lower, or 0.9 or lower. The occupancy of the through area 57 in the mask second area M2 may fall within a range defined by a first group consisting of 0.1, 0.2, and 0.4 and/or a second group consisting of 0.6, 0.8, and 0.9. The occupancy of the through area 57 in the mask second area M2 may fall within a range defined by a combination of any one of the values included in the aforementioned first group and any one of the values included in the aforementioned second group. The occupancy of the through area 57 in the mask second area M2 may fall within a range defined by a combination of any two of the values included in the aforementioned first group. The occupancy of the through area 57 in the mask second area M2 may fall within a range defined by a combination of any two of the values included in the aforementioned second group. The occupancy of the through area 57 in the mask second area M2 may for example be 0.1 or higher and 0.9 or lower, 0.1 or higher and 0.8 or lower, 0.1 or higher and 0.6 or lower, 0.1 or higher and 0.4 or lower, 0.1 or higher and 0.2 or lower, 0.2 or higher and 0.9 or lower, 0.2 or higher and 0.8 or lower, 0.2 or higher and 0.6 or lower, 0.2 or higher and 0.4 or lower, 0.4 or higher and 0.9 or lower, 0.4 or higher and 0.8 or lower, 0.4 or higher and 0.6 or lower, 0.6 or higher and 0.9 or lower, 0.6 or higher and 0.8 or lower, or 0.8 or higher and 0.9 or lower.

The through area 57 may include a hole overlap area 59. The hole overlap area 59 is an area where the through holes 54 of two or more masks 50 overlap each other in plan view. That is, the hole overlap area 59 includes, in a plan view, at least two of the through holes 54 of two or more masks 50 included in the mask stack 56. In the example shown in Fig. 17, the hole overlap area 59 includes an area where the first through hole 54A and the second through hole 54B overlap each other in plan view. Accordingly, in the vapor deposition step, at least two layers of second electrode 140 are formed in an area of the substrate 110 corresponding to the hole overlap area 59.

The area of the hole overlap area 59 may be smaller than the area of the second through hole 54B of the second mask 50B. The ratio of the area of the hole overlap area 59 to the area of the second through hole 54B may for example be 0.02 or higher, 0.05 or higher, or 0.10 or higher. The ratio of the area of the hole overlap area 59 to the area of the second through hole 54B may for example be 0.20 or lower, 0.30 or lower, or 0.40 or lower. The ratio of the area of the hole overlap area 59 to the area of the second through hole 54B may fall within a range defined by a first group consisting of 0.02, 0.05, and 0.10 and/or a second group consisting of 0.20, 0.30, and 0.40. The ratio of the area of the hole overlap area 59 to the area of the second through hole 54B may fall within a range defined by a combination of any one of the values included in the aforementioned first group and any one of the values included in the aforementioned second group. The ratio of the area of the hole overlap area 59 to the area of the second through hole 54B may fall within a range defined by a combination of any two of the values included in the aforementioned first group. The ratio of the area of the hole overlap area 59 to the area of the second through hole 54B may fall within a range defined by a combination of any two of the values included in the aforementioned second group. The ratio of the area of the hole overlap area 59 to the area of the second through hole 54B may for example be 0.02 or higher and 0.40 or lower, 0.02 or higher and 0.30 or lower, 0.02 or higher and 0.20 or lower, 0.02 or higher and 0.10 or lower, 0.02 or higher and 0.05 or lower, 0.05 or higher and 0.40 or lower, 0.05 or higher and 0.30 or lower, 0.05 or higher and 0.20 or lower, 0.05 or higher and 0.10 or lower, 0.10 or higher and 0.40 or lower, 0.10 or higher and 0.30 or lower, 0.10 or higher and 0.20 or lower, 0.20 or higher and 0.40 or lower, 0.20 or higher and 0.30 or lower, or 0.30 or higher and 0.40 or lower.

Next, an example of a method for manufacturing an organic device 200 is described.

First, a substrate 110 is prepared with first electrodes 120 formed thereon. The first electrodes 120 are formed, for example, by, after a conductive layer that constitutes the first electrodes 120 has been formed on the substrate 110 by a sputtering method or other method, patterning the conductive layer by a photolithography method or other methods. An insulating layer 160 located between two first electrodes 120 adjacent to each other in plan view may be formed on the substrate 110.

Then, as shown in Fig. 5, organic layers 130 including first organic layers 130A, second organic layers 130B, and third organic layers 130C are formed on top of the first electrodes 120. The first organic layers 130A may be formed, for example, by a vapor deposition method that involves the use of a mask including through holes corresponding to the first organic layer 130A. For example, the first organic layers 130A can be formed by depositing an organic material or other material on top of first electrodes 120 corresponding to the first organic layers 130A via the mask. The second organic layers 130B too may be formed by a vapor deposition method that involves the use of a mask including through holes corresponding to the second organic layers 130B. The third organic layers 130C too may be formed by a vapor deposition method that involves the use of a mask including through holes corresponding to the third organic layers 130C.

Then, a second electrode forming step may be executed. In the second electrode forming step, the aforementioned group of masks is used to form a second electrode 140 on top of the organic layers 130. First, a step of forming a first layer 140A of the second electrode 140 by a vapor deposition method that involves the use of a first mask 50A may be executed. For example, an electrically-conducting material such as a metal or other materials are deposited on the organic layers 130 or other layers via the first mask 50A. This makes it possible to form the first layer 140A. Then, a step of forming a second layer 140B of the second electrode 140 by a vapor deposition method that involves the use of a second mask 50B may be executed. For example, an electrically-conducting material such as a metal or other materials are deposited on the organic layers 130 or other layers via the second mask 50B. This makes it possible to form the second layer 140B. Thus, as shown in Fig. 4, the second electrode 140, which includes the first layer 140A and the second layer 140B, can be formed.

It should be noted that the first layer 140A and the second layer 140B may be formed in any order. For example, a vapor deposition step may be executed in the order of the second layer 140B and then the first layer 140A.

Effects of the present disclosure are summarized.

In a case where the second display area 102 of the organic device 200 includes a transmissive area 104, light having arrived at the organic device 200 can pass through the transmissive area 104 and arrive at an optical component or other components on a back side of the substrate. Accordingly, the second display area 102 can detect light and display a picture. For this reason, the function of a sensor such as a camera or a fingerprint sensor can be achieved in the second display area 102.

Since the first display area 101 includes a wide-area electrode 140X that spreads in a gapless manner, the transmittance of light in the first display area 101 can be restrained from varying from position to position. This makes it possible to reduce the occurrence of unevenness in intensity of light in the first display area 101.

It should be noted that various modifications can be added to the foregoing embodiment. The following describes other embodiments with reference to the drawings on an as-needed basis. In the following description and the drawings that are used in the following description, components that are configured in a manner similar to those of the foregoing embodiment are assigned signs identical to those assigned to the corresponding components of the foregoing embodiment, and a repeated description of such components is omitted. Further, in a case where it is obvious that working effects of the foregoing embodiment can be brought about by other embodiments too, a description of such working effects may be omitted.

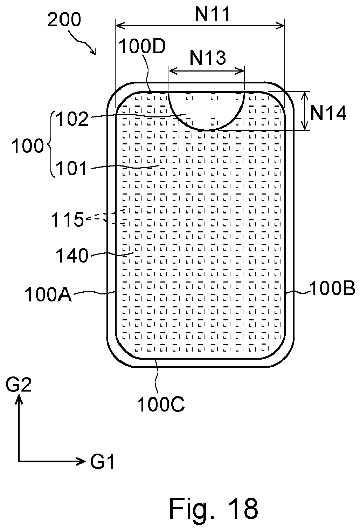

Although the foregoing embodiment has illustrated an example in which the boundary between the first display area 101 and the second display area 102 includes a straight line, the boundary may assume any shape. For example, as shown in Fig. 18, the boundary between the first display area 101 and the second display area 102 may include a curve.

The shape of the boundary between the first display area 101 and the second display area 102 may be defined by the contours of the first shielding area 55A of the first mask 50A. The contours of the first shielding area 55A may include a straight line or may include a curve.

A mask first area M1 of a mask 50 may be configured in any way, provided the second electrode 140 can be formed on top of each organic layer 130 of the first display area 101. Although the foregoing embodiment has illustrated an example in which a mask first area M1 of the first mask 50A includes a wide-area through hole 54A1, the mask first area M1 may be configured in other ways. For example, a mask first area M1 of the first mask 50A may include a plurality of first through holes 54A, and a mask first area M1 of the second mask 50B may include a plurality of second through holes 54B partially overlapping the first through holes 54A.

The foregoing embodiment has illustrated an example in which a mask first area M1 of the first mask 50A includes a wide-area through hole 54A1 and first through holes 54A of a mask second area M2 of the first mask 50A constitutes first through sections 571 overlapping organic layers 130. Although not illustrated, a mask first area M1 of the first mask 50A may include a wide-area through hole 54A1, and first through holes 54A of a mask second area M2 of the first mask 50A may constitute second through sections 572 connected to first through sections 571. In this case, the second mask 50B may not include a wide-area through hole, and second through holes 54B of a mask second area M2 of the second mask 50B may constitute first through sections 571 overlapping organic layers 130. In this case, a first layer 140A formed by the first mask 50A constitutes a wide-area electrode 140X and connection sections 142. The second layer 140B formed by the second mask 50B constitutes pixel sections 141.

Since the first mask 50A includes the wide-area through hole 54A1, it is hard to apply tension to the mask second area M2 of the first mask 50A. Meanwhile, since the second mask 50B does not include a wide-area through hole, it is easier to apply tension to the mask second area M2 of the second mask 50B than to the mask second area M2 of the first mask 50A. For this reason, the alignment accuracy of the second through holes 54B of the mask second area M2 of the second mask 50B may be higher than the alignment accuracy of first through holes 54A of the mask second area M2 of the first mask 50A. When the second through holes 54B of the mask second area M2 of the second mask 50B constitute the first through sections 571, the positional accuracy of the pixel sections 141 can be increased.

Although not illustrated, the first mask 50A may include a wide-area through hole 54A1, and each of first through holes 54A of a mask second area M2 of the first mask 50A may include a portion constituting a first through section 571 and a portion constituting a second through section 572. Alternatively, the second mask 50B may not include a wide-area through hole, and each of second through holes 54B of a mask second area M2 of the second mask 50B may include a portion constituting a first through section 571 and a portion constituting a second through section 572.

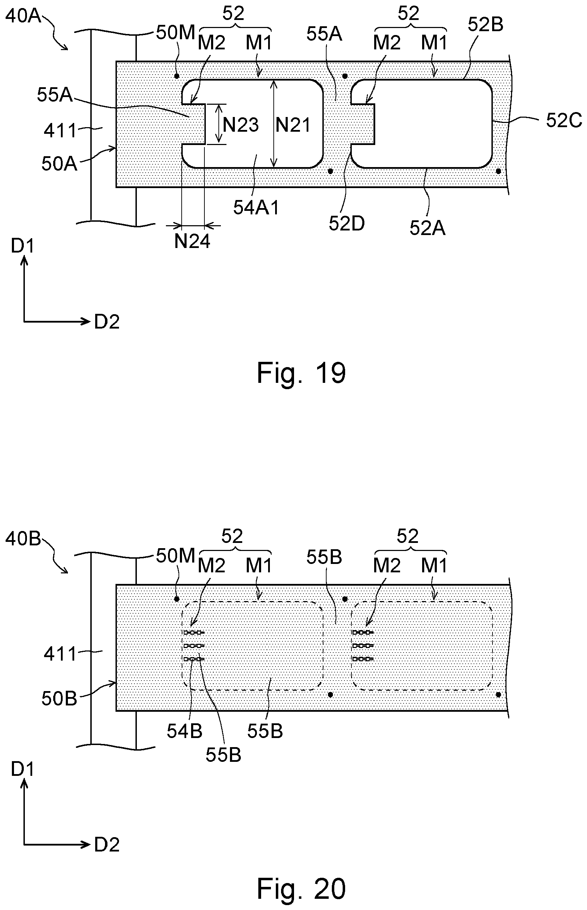

Fig. 19 is a diagram showing an example of a first mask 50A, and Fig. 20 is a diagram showing an example of a second mask 50B. As shown in Fig. 19, a mask first area M1 of the first mask 50A may include a wide-area through hole 54A1, and a mask second area M2 of the first mask 50A may not include a first through hole 54A. In this case, as shown in Fig. 20, the second mask 50B may not include a wide-area through hole, and each of second through holes 54B of a mask second area M2 of the second mask 50B may constitute both a first through section 571 and a second through section 572.

In a case where the first mask 50A shown in Fig. 19 and the second mask 50B shown in Fig. 20 are used, the second electrode 140 located in the second display area 102 does not include a first overlap area 145A. Meanwhile, at the boundary between the first display area 101 and the second display area 102, the first layer 140A formed by the first mask 50A and the second layer 140B formed by the second mask 50B overlap each other. For this reason, in a case where the first mask 50A shown in Fig. 19 and the second mask 50B shown in Fig. 20 are used, second overlap areas 145B are formed.

## Claims

1. An organic device comprising:
a substrate;
first electrodes located on top of the substrate;
organic layers located on top of the first electrodes; and
a second electrode located on top of the organic layers, wherein
when seen along a direction normal to the substrate, the organic device includes a display area including a first display area and a second display area,
the first display area includes the organic layers distributed at a first density,
the second display area includes the organic layers distributed at a second density that is lower than the first density, and
the second electrode includes a wide-area electrode spreading in a gapless manner in the first display area and two or more electrode lines overlapping the organic layers in the second display area, each of the electrode lines including an end connected to the wide-area electrode.

2. The organic device according to Claim 1, wherein
the display area includes contours including first and second sides that are opposite to each other in a first direction and third and fourth sides that are opposite to each other in a second direction intersecting the first direction, and
the wide-area electrode spreads along the first side, the second side, and the third side.

3. The organic device according to Claim 2, wherein the second display area is in contact with the fourth side.

4. The organic device according to any one of Claims 1 to 3, wherein each of the electrode lines includes a pixel section overlapping at least one of the organic layers and a connection section connected to the pixel section, the connection section having a width that is smaller than a width of the pixel section.

5. The organic device according to Claim 4, wherein the second electrode includes a first layer constituting at least the wide-area electrode and a second layer partially overlapping the first layer and constituting at least the connection section.

6. The organic device according to Claim 5, wherein the first layer includes portions, each of the portions constituting the pixel section.

7. The organic device according to Claim 6, wherein each of the portions of the first layer constituting the pixel section overlaps two or more of the organic layers.

8. The organic device according to Claim 6, wherein each of the portions of the first layer constituting the pixel section overlaps one of the organic layers.

9. The organic device according to any one of Claims 1 to 8, wherein a ratio of the second density to the first density is 0.9 or lower.

10. A group of masks comprising two or more masks,
wherein
each of the masks includes a shielding area and at least one through hole,
a mask stack of the two or more masks includes a through area that overlaps the at least one through hole when seen along a direction normal to the masks,
when seen along the direction normal to the masks, the mask stack includes a cell including a mask first area and a mask second area,
in the mask first area, the through area spreads in a gapless manner, and
in the mask second area, the through area includes two or more through lines located in the mask second area, each of the through lines including an end connected to the mask first area.

11. The group of masks according to Claim 10, wherein
the cell includes cell contours including cell first and second sides that are opposite to each other in a mask first direction and cell third and fourth sides that are opposite to each other in a mask second direction intersecting the mask first direction, and
the through area spreads along the cell first side, the cell second side, and the cell third side in the mask first area.

12. The group of masks according to Claim 11, wherein the mask second area is in contact with the cell fourth side.

13. The group of masks according to any one of Claims 10 to 12, wherein each of the through lines includes a first through section and a second through section connected to the first through section, the second through section having a width that is smaller than a width of the first through section.

14. The group of masks according to any one of Claims 10 to 13, wherein the two or more masks include
a first mask including a first wide-area through hole spreading in a gapless manner in the mask first area, and
a second mask including two or more second through holes constituting the through lines in the mask second area.

15. The group of masks according to Claim 14, wherein the first mask includes two or more first through holes located in the mask second area, the first through holes partially overlapping the second through holes when seen along the direction normal to the masks.

16. The group of masks according to any one of Claims 10 to 15, wherein in the mask second area, the through area has an occupancy of 0.9 or lower.

17. A mask including a shielding area and through holes, the mask comprising a cell including a mask first area and a mask second area when seen along a direction normal to the mask,
wherein
in the mask first area, one of the through holes spreads in a gapless manner, and
the mask second area includes the shielding area and two or more of the through holes surrounded by the shielding area.

18. The mask according to Claim 17, wherein
the cell includes cell contours including cell first and second sides that are opposite to each other in a mask first direction and cell third and fourth sides that are opposite to each other in a mask second direction intersecting the mask first direction, and
the through hole in the mask first area spreads along the cell first side, the cell second side, and the cell third side.

19. The mask according to Claim 18, wherein the mask second area is in contact with the cell fourth side.

20. A manufacturing method for an organic device, the method comprising a second electrode forming step of forming a second electrode on top of an organic layer on top of a first electrode on top of a substrate by using the group of masks according to Claim 10,
wherein the second electrode forming step includes
forming a first layer of the second electrode by a vapor deposition method that involves use of the first mask, and
forming a second layer of the second electrode by a vapor deposition method that involves use of the second mask.
